# EUROPEAN PATENT APPLICATION

(11) **EP 4 539 102 A1**
(43) Date of publication of application: **16.04.2025**
(21) Application number: 23823779.6
(22) Date of filing: 06.06.2023
(51) Int. Cl.: H01L 21/301, B32B 7/06, B32B 27/00, H01L 21/304

(54) **ADHESIVE SHEET FOR PROVISIONAL FIXATION OF ELECTRONIC COMPONENT**

(30) Priority: 13.06.2022 JP 2022095264
(71) Applicant: Nitto Denko Corporation, Ibaraki-shi, Osaka 567-8680 (JP)
(72) Inventor: UENO, Shusaku, Ibaraki-shi, Osaka 567-8680 (JP); KATO, Kazumichi, Ibaraki-shi, Osaka 567-8680 (JP); KATAOKA, Naoki, Ibaraki-shi, Osaka 567-8680 (JP)
(74) Representative: Müller-Boré & Partner Patentanwälte PartG mbB
(86) International application number: PCT/JP2023/020975
(87) International publication number: WO 2023/243487

(57) **Abstract**

Provided is a pressure-sensitive adhesive sheet for temporarily fixing an electronic part that shows peelability by irradiation with light, the pressure-sensitive adhesive sheet for temporarily fixing an electronic part having a wide range of selection of the light to be applied. The pressure-sensitive adhesive sheet for temporarily fixing an electronic part of the present invention includes: a laminated structure A including a first photothermal conversion layer and a second photothermal conversion layer arranged on at least one side of the first photothermal conversion layer; and a pressure-sensitive adhesive layer arranged on at least one side of the laminated structure A. The pressure-sensitive adhesive sheet has a transmittance for light having a wavelength of 1,032 nm of 75% or less, and has a transmittance for light having a wavelength of 355 nm of 50% or less.

## Description

### Technical Field

The present invention relates to a pressure-sensitive adhesive sheet for temporarily fixing an electronic part.

### Background Art

In recent years, for improvements in characteristics of a semiconductor device, there has been a growing trend toward performing a high-temperature process by fixing a semiconductor chip or a resin substrate after sealing to a hard support substrate mainly in fields such as semiconductor packaging. For example, in, for example, a RDL formation process for forming a circuit on a semiconductor package sealed with a black resin, there has been investigated a method involving temporarily fixing a workpiece to an optically transparent substrate such as glass in a flat manner and separating the hard substrate after performing the RDL formation on the workpiece. In such usage, a liquid adhesive containing carbon black powder as a photothermal conversion material is widely used. In a technology involving using a photothermal conversion material, a photothermal conversion layer is formed on an optically transparent substrate through application of the photothermal conversion material thereon. Accordingly, a workpiece can be firmly fixed at the time of processing, and the workpiece and the optically transparent substrate can be easily separated from each other by irradiation with laser light having a predetermined wavelength, and thermal decomposition of the photothermal conversion layer through absorption of the light and conversion of the light into heat at the time of peeling. However, there is a problem in that, when the liquid adhesive for photothermal conversion is used, the wavelength of the laser light to be applied is required to be changed in accordance with the photothermal conversion material, and hence the production process becomes complicated.

### Citation List

### Patent Literature

[PTL 1] JP 4565804 B2
[PTL 2] JP 4405246 B2
[PTL 3] JP 6980999 B2

### Summary of Invention

### Technical Problem

The present invention has been made to solve the above-mentioned problem, and an object of the present invention is to provide a pressure-sensitive adhesive sheet for temporarily fixing an electronic part that shows peelability by irradiation with light, the pressure-sensitive adhesive sheet for temporarily fixing an electronic part having a wide range of selection of the light to be applied.

### Solution to Problem

According to one aspect of the present invention, there is provided a pressure-sensitive adhesive sheet for temporarily fixing an electronic part, including: a laminated structure A including a first photothermal conversion layer and a second photothermal conversion layer arranged on at least one side of the first photothermal conversion layer; and a pressure-sensitive adhesive layer arranged on at least one side of the laminated structure A, wherein the pressure-sensitive adhesive sheet has a transmittance for light having a wavelength of 1,032 nm of 75% or less, and wherein the pressure-sensitive adhesive sheet has a transmittance for light having a wavelength of 355 nm of 50% or less.

In one embodiment, the first photothermal conversion layer is a layer capable of absorbing UV light.

In one embodiment, the first photothermal conversion layer includes a polyimide-based resin, a polyester-based resin, or a polyetheretherketone-based resin.

In one embodiment, the first photothermal conversion layer has a 5% weight loss temperature of 300°C or more.

In one embodiment, the second photothermal conversion layer is a layer capable of absorbing a near infrared ray.

In one embodiment, the second photothermal conversion layer contains a near infrared ray absorber.

In one embodiment, the near infrared ray absorber is a substance containing a tungsten element.

In one embodiment, the near infrared ray absorber is a substance containing a cesium element.

In one embodiment, the second photothermal conversion layer has a 5% weight loss temperature of 300°C or more.

According to another aspect of the present invention, there is provided a method of treating an electronic part. This treatment method includes subjecting an electronic part to predetermined treatment after arranging the electronic part on the above-mentioned pressure-sensitive adhesive sheet.

In one embodiment, the treatment is grinding processing, dicing processing, die bonding, wire bonding, etching, vapor deposition, chemical cleaning, molding, rewiring layer formation, through-hole formation, or protection of a device surface.

According to another aspect of the present invention, there is provided a method of separating, from a support, an electronic part that has been temporarily fixed thereto, the method including: arranging the above-mentioned pressure-sensitive adhesive sheet for temporarily fixing an electronic part on the support; arranging the electronic part on the pressure-sensitive adhesive sheet for temporarily fixing an electronic part; and then irradiating the above-mentioned pressure-sensitive adhesive sheet with light to separate the above-mentioned first photothermal conversion layer and the above-mentioned second photothermal conversion layer from each other.

In one embodiment, the light is laser light.

In one embodiment, the laser light has a wavelength of 800 nm or more.

In one embodiment, the laser light has a wavelength of 380 nm or less.

### Advantageous Effects of Invention

According to the present invention, it is possible to provide the pressure-sensitive adhesive sheet for temporarily fixing an electronic part that shows peelability by irradiation with light, the pressure-sensitive adhesive sheet for temporarily fixing an electronic part having the wide range of selection of the light to be applied.

### Brief Description of Drawings

FIG. **1** is a schematic sectional view of a pressure-sensitive adhesive sheet for temporarily fixing an electronic part according to one embodiment of the present invention.
FIGS. **2** are each a view for illustrating a method of using the pressure-sensitive adhesive sheet for temporarily fixing an electronic part in one embodiment of the present invention.
FIGS. **3** are each a view for illustrating a method of using the pressure-sensitive adhesive sheet for temporarily fixing an electronic part in one embodiment of the present invention.

### Description of Embodiments

### A. Outline of Pressure-sensitive Adhesive Sheet for temporarily fixing Electronic Part

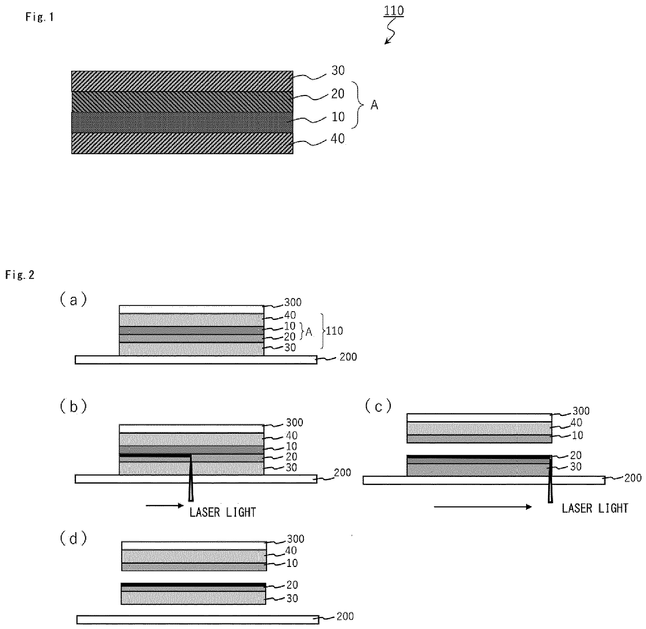

FIG. **1** is a schematic sectional view of a pressure-sensitive adhesive sheet for temporarily fixing an electronic part according to one embodiment of the present invention. A pressure-sensitive adhesive sheet **110** for temporarily fixing an electronic part includes: a laminated structure A including a first photothermal conversion layer **10** and a second photothermal conversion layer **20** arranged on at least one side of the first photothermal conversion layer **10;** and a pressure-sensitive adhesive layer **30** arranged on at least one side of the laminated structure A. The photothermal conversion layers are each a layer that absorbs light having a predetermined wavelength and converts the light into heat. Each photothermal conversion layer itself is decomposed or a layer adjacent to the photothermal conversion layer is thermally decomposed by the heat generation of the photothermal conversion layer. As a result, the pressure-sensitive adhesive sheet for temporarily fixing an electronic part shows peelability. In one embodiment, the second photothermal conversion layer is thermally decomposed by the heat generation of the first or second photothermal conversion layer to generate a gas, and the shape of the surface of the second photothermal conversion layer changes. Thus, the first photothermal conversion layer and the second photothermal conversion layer can be easily separated (peeled) from each other. The term "thermal decomposition" as used herein means that a weight reduction of 5% or more may occur through heating to 250°C or more. The pressure-sensitive adhesive sheet for temporarily fixing an electronic part may further include any other layer as long as the effect of the present invention is obtained. For example, the pressure-sensitive adhesive sheet **110** may further include another pressure-sensitive adhesive layer **40** arranged on the first photothermal conversion layer **10** side of the laminated structure A. The pressure-sensitive adhesive sheet for temporarily fixing an electronic part is hereinafter sometimes simply referred to as "pressure-sensitive adhesive sheet."

In one embodiment, the first photothermal conversion layer and the second photothermal conversion layer are directly arranged. When the first photothermal conversion layer and the second photothermal conversion layer are directly arranged, in the case of generation of heat in the first photothermal conversion layer, the heat preferably propagates to the second photothermal conversion layer, and hence gas generation preferably occurs. The term "directly arranged" means a state in which any other layer is free from being arranged between the first photothermal conversion layer and the second photothermal conversion layer, and these layers are brought into contact with each other.

The transmittance of the pressure-sensitive adhesive sheet for temporarily fixing an electronic part for light having a wavelength of 1,032 nm is 75% or less. In addition, the transmittance of the pressure-sensitive adhesive sheet for temporarily fixing an electronic part for light having a wavelength of 600 nm is preferably 50% or more. The transmittance for light having a wavelength of 1,032 nm is preferably 65% or less, more preferably 50% or less, still more preferably 40% or less, particularly preferably 30% or less, most preferably 20% or less. The lower limit of the transmittance for light having a wavelength of 1,032 nm is, for example, 1% (preferably 0.5%). The transmittance for light having a wavelength of 600 nm is more preferably 60% or more, still more preferably 70% or more, particularly preferably 80% or more. The upper limit of the transmittance for light having a wavelength of 600 nm is, for example, 90% (preferably 95%). According to the pressure-sensitive adhesive sheet for temporarily fixing an electronic part, there is an advantage not only in that the pressure-sensitive adhesive sheet may absorb laser light to exhibit peelability, but also in that the pressure-sensitive adhesive sheet is excellent in visibility through the pressure-sensitive adhesive sheet.

The transmittance of the pressure-sensitive adhesive sheet for temporarily fixing an electronic part for light having a wavelength of 355 nm is 50% or less. The adjustment of the transmittance of the first photothermal conversion layer for light having a wavelength of 355 nm and the setting of the transmittance of the pressure-sensitive adhesive sheet for temporarily fixing an electronic part for light having a wavelength of 355 nm within such ranges enable the heat generation of the first photothermal conversion layer by UV laser light, and hence a pressure-sensitive adhesive sheet for temporarily fixing an electronic part that can also exhibit peelability by UV laser light can be obtained. The transmittance of the pressure-sensitive adhesive sheet for temporarily fixing an electronic part for light having a wavelength of 355 nm is more preferably from 0% to 30%, still more preferably from 0% to 20%. When the transmittance falls within such ranges, the effect of the present invention becomes significant.

In one embodiment, there is provided a method of separating, from a support, an electronic part that has been temporarily fixed thereto, the method including: arranging a pressure-sensitive adhesive sheet for temporarily fixing an electronic part on the support; arranging the electronic part on the pressure-sensitive adhesive sheet for temporarily fixing an electronic part; and then irradiating the photothermal conversion layer (first photothermal conversion layer or second photothermal conversion layer) with light to separate the first photothermal conversion layer and the second photothermal conversion layer from each other. The details are described below. In one embodiment, the pressure-sensitive adhesive sheet for temporarily fixing an electronic part is used by: bonding the pressure-sensitive adhesive sheet to a support via a pressure-sensitive adhesive layer; and arranging an electronic part (e.g., a semiconductor part such as a semiconductor wafer) on the first photothermal conversion layer side thereof. In one embodiment, the pressure-sensitive adhesive sheet may show such behavior as shown in FIGS. 2 and as described below. The pressure-sensitive adhesive sheet **110** illustrated in FIGS. **2** includes: the laminated structure A (first photothermal conversion layer/second photothermal conversion layer); and the pressure-sensitive adhesive layer **30** arranged on the second photothermal conversion layer **20** side of the laminated structure A. In this embodiment, a second photothermal conversion layer that may absorb an infrared ray is used, and hence the second photothermal conversion layer exhibits a photothermal conversion function.
(1) The pressure-sensitive adhesive sheet **110** is arranged on a support **200** so that the pressure-sensitive adhesive layer **30** side thereof may be on the support **200** side, and an electronic part **300** serving as a workpiece is further arranged on the side of the pressure-sensitive adhesive sheet **110** opposite to the support **200** (FIG. **2(a)**). The electronic part **300** may be bonded to the pressure-sensitive adhesive sheet **110** via, for example, another pressure-sensitive adhesive layer **40.**
(2) When the pressure-sensitive adhesive sheet **110** (substantially, the second photothermal conversion layer) arranged on the support **200** is irradiated with IR laser light (e.g., having a wavelength of 800 nm or more) from the support **200** side, the second photothermal conversion layer **20** generates heat, and hence the second photothermal conversion layer **20** is thermally decomposed to generate a gas (FIG. **2(b)**).
(3) As a result, the shape of the surface of the second photothermal conversion layer **20** changes, and the second photothermal conversion layer **20** shows peelability from the first photothermal conversion layer **10.** With this, peeling of the first photothermal conversion layer **10** (the first photothermal conversion layer **10** with the electronic part **300**) from the support **200** is enabled (FIG. **2(c)**). As a result, separation of the electronic part **300** from the support **200** can be performed.
(4) Next, a laminated structure including the pressure-sensitive adhesive layer **30** and the second photothermal conversion layer **20** on the support **200** is peeled. Thus, a clean support **200** suppressed in residue can be recovered (FIG. **2(d)**).

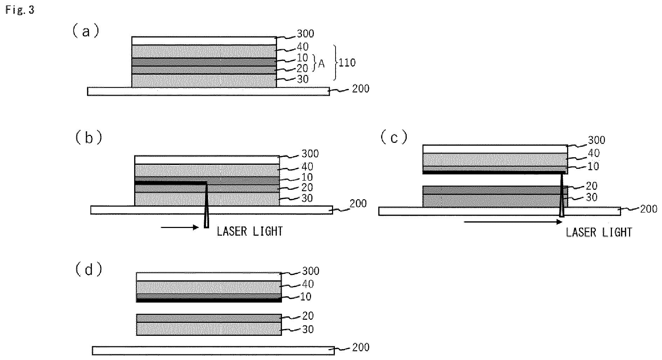

In another embodiment, the pressure-sensitive adhesive sheet may show such behavior as shown in FIGS. **3** and as described below. The pressure-sensitive adhesive sheet **110** illustrated in FIGS. **3** includes: the laminated structure A (first photothermal conversion layer/second photothermal conversion layer); and the pressure-sensitive adhesive layer **30** arranged on the second photothermal conversion layer **20** side of the laminated structure A. In this embodiment, a first photothermal conversion layer that may absorb UV light is used, and hence the first photothermal conversion layer exhibits a photothermal conversion function.
(1) The pressure-sensitive adhesive sheet **110** is arranged on the support **200** so that the pressure-sensitive adhesive layer **30** side thereof may be on the support **200** side, and the electronic part **300** serving as a workpiece is further arranged on the side of the pressure-sensitive adhesive sheet **110** opposite to the support **200** (FIG. **3(a)**). The electronic part **300** may be bonded to the pressure-sensitive adhesive sheet **110** via, for example, another pressure-sensitive adhesive layer **40.**
(2) When the pressure-sensitive adhesive sheet **110** (substantially, the first photothermal conversion layer) arranged on the support **200** is irradiated with UV laser light (e.g., having a wavelength of 380 nm or less) from the support **200** side, the first photothermal conversion layer **10** generates heat, and hence the second photothermal conversion layer **20** is thermally decomposed to generate a gas (FIG. **3(b)**).
(3) As a result, the shape of the surface of the second photothermal conversion layer **20** changes, and the second photothermal conversion layer **20** shows peelability from the first photothermal conversion layer **10.** With this, peeling of the first photothermal conversion layer **10** (the first photothermal conversion layer **10** with the electronic part **300**) from the support **200** is enabled (FIG. **3(c)**). As a result, separation of the electronic part **300** from the support **200** can be performed.
(4) Next, a laminated structure including the pressure-sensitive adhesive layer **30** and the second photothermal conversion layer **20** on the support **200** is peeled. Thus, a clean support **200** suppressed in residue can be recovered (FIG. **3(d)**).

The pressure-sensitive adhesive sheet having the above-mentioned characteristics may be obtained by, for example, incorporating an appropriate near infrared ray absorber in the second photothermal conversion layer formed of a resin, and using a material that can absorb UV light as a material for forming the first photothermal conversion layer.

According to the present invention, when two kinds of photothermal conversion layers are formed into a configuration having a transmittance for light having a wavelength of 1,032 nm of 75% or less and a transmittance for light having a wavelength of 355 nm of 50% or less, a pressure-sensitive adhesive sheet for temporarily fixing an electronic part that can generate peelability by any one of an infrared ray and UV light, and having a wide range of selection of the light to be applied can be obtained.

A pressure-sensitive adhesive strength of the pressure-sensitive adhesive sheet at 23°C when the pressure-sensitive adhesive layer is bonded to a PET is preferably from 0.2 N/20 mm to 10 N/20 mm, more preferably from 3 N/20 mm to 8 N/20 mm. When the pressure-sensitive adhesive strength falls within such ranges, a pressure-sensitive adhesive sheet suitable for an application of temporary fixing without causing a positional shift or the like on the support can be obtained. A pressure-sensitive adhesive strength is measured in conformity with JIS Z 0237:2000. Specifically, the measurement is performed by: reciprocating a 2-kilogram roller once to bond a thermal decomposition layer to a glass plate (arithmetic average surface roughness Ra: 10±8 nm); and then peeling the pressure-sensitive adhesive sheet under the conditions of a peel angle of 180° and a peel rate (tensile rate) of 300 mm/min.

A pressure-sensitive adhesive strength of the pressure-sensitive adhesive sheet at 23°C when the pressure-sensitive adhesive layer is bonded to SUS430 is preferably from 0.20 N/20 mm to 10 N/20 mm, more preferably from 3 N/20 mm to 7 N/20 mm. When the pressure-sensitive adhesive strength falls within such ranges, a pressure-sensitive adhesive sheet suitable for an application of temporary fixing without causing a positional shift or the like on the support can be obtained.

The thickness of the pressure-sensitive adhesive sheet for temporarily fixing an electronic part is preferably from 10 µm to 500 µm, more preferably from 20 µm to 400 µm.

### B. First Photothermal Conversion Layer

In one embodiment, the first photothermal conversion layer may also function as a base material in the pressure-sensitive adhesive sheet.

In one embodiment, the first photothermal conversion layer is a layer capable of absorbing UV light.

The first photothermal conversion layer may include any appropriate resin as long as the effect of the present invention is obtained. The first photothermal conversion layer preferably includes a polyimide-based resin, a polyester-based resin, or a polyetheretherketone-based resin. Of those, a polyimide-based resin is preferred. Those resins each have UV absorbability, and when each of the resins is used, a pressure-sensitive adhesive sheet that may exhibit peelability by UV laser light can be obtained.

The thickness of the first photothermal conversion layer is preferably from 2 µm to 300 µm, more preferably from 2 µm to 100 µm, still more preferably from 2 µm to 50 µm.

In one embodiment, the transmittance of the first photothermal conversion layer for light having a wavelength of 1,032 nm is from 60% to 95%, preferably from 70% to 90%.

In one embodiment, the transmittance of the first photothermal conversion layer for light having a wavelength of 600 nm is preferably 50% or more, more preferably 60% or more, still more preferably 70% or more, most preferably 80% or more. The upper limit of the transmittance of the first photothermal conversion layer for light having a wavelength of 600 nm is, for example, 95% (preferably 99%).

In one embodiment, the transmittance of the first photothermal conversion layer for light having a wavelength of 355 nm is preferably 50% or less, more preferably from 0% to 20%. When the transmittance falls within such ranges, a pressure-sensitive adhesive sheet that may exhibit peelability by UV laser light can be obtained.

The tensile modulus of elasticity at 200°C of the first photothermal conversion layer is preferably from 5 MPa to 2 GPa, more preferably from 10 MPa to 1.8 GPa, still more preferably from 500 MPa to 1.8 GPa, particularly preferably from 1 GPa to 1.5 GPa. When the tensile modulus of elasticity falls within such ranges, a gas generated by irradiation with laser light is preferably barriered by the first photothermal conversion layer, and hence peelability resulting from a change in shape of the surface of the second photothermal conversion layer is preferably exhibited. The tensile modulus of elasticity may be measured with a dynamic viscoelasticity-measuring apparatus. A specific measurement method is described later.

The 5% weight loss temperature of the first photothermal conversion layer is preferably 300°C or more, more preferably from 350°C to 650°C, still more preferably from 380°C to 600°C, particularly preferably from 400°C to 590°C. When the 5% weight loss temperature falls within such ranges, a pressure-sensitive adhesive sheet excellent in heat resistance can be obtained. In addition, in general, a RDL formation process is performed at a temperature of 250°C or less, and hence, when the 5% weight loss temperature falls within the above-mentioned ranges, an outgas from the first photothermal conversion layer (base material) in the RDL formation process reduces to alleviate an influence on the electronic part. Thus, a stable process can be achieved. In addition, when the 5% weight loss temperature of the first photothermal conversion layer (base material) falls within the above-mentioned ranges, a damage at the time of laser irradiation is hardly caused, and hence, when a tape (pressure-sensitive adhesive layer/base material) is peeled from the electronic part, the tape can be removed without breakage. The 5% weight loss temperature means a temperature at the time point when the weight of a sample to be evaluated at the time of an increase in temperature of the sample reduces by 5 wt% as compared to the dry weight of the sample before the temperature increase. The 5% weight loss temperature is measured with a differential thermal analyzer under the measurement conditions of a rate of temperature increase of 10°C/min and a flow rate of 25 ml/min under a nitrogen atmosphere. The dry weight of the sample means the weight except moisture in the sample.

### C. Second Photothermal Conversion Layer

In one embodiment, the second photothermal conversion layer is a layer that may be thermally decomposed by the application of heat to generate a gas. The heat to be applied may be caused by the heat generation of the second photothermal conversion layer, or may be caused by the heat generation of the first photothermal conversion layer.

In one embodiment, the second photothermal conversion layer is a layer capable of absorbing a near infrared ray. More specifically, the transmittance of the second photothermal conversion layer for light having a wavelength of 1,032 nm is 75% or less, preferably 50% or less, more preferably 40% or less, still more preferably 35% or less, most preferably 20% or less. When the transmittance falls within such ranges, a second photothermal conversion layer that preferably absorbs IR laser light and easily generates heat can be formed. The lower limit of the transmittance of the second photothermal conversion layer for light having a wavelength of 1,032 nm is, for example, 5% (preferably 1%).

In one embodiment, the transmittance of the second photothermal conversion layer for light having a wavelength of 600 nm is preferably 50% or more, more preferably 60% or more, still more preferably 70% or more, most preferably 80% or more. When the transmittance falls within such ranges, a second photothermal conversion layer that may contribute to an improvement in visibility can be formed. The upper limit of the transmittance of the second photothermal conversion layer for light having a wavelength of 600 nm is, for example, 90% (preferably 95%).

In one embodiment, the transmittance of the second photothermal conversion layer for light having a wavelength of 355 nm is preferably 40% or more, more preferably from 50% to 95%. When the transmittance falls within such ranges, a pressure-sensitive adhesive sheet that may exhibit peelability even by UV laser light by appropriately selecting the first photothermal conversion layer capable of absorbing UV light can be obtained.

The thickness of the second photothermal conversion layer is preferably from 1 µm to 100 µm, more preferably from 2 µm to 50 µm, still more preferably from 3 µm to 30 µm, particularly preferably from 5 µm to 20 µm.

The 5% weight loss temperature of the second photothermal conversion layer is preferably 300°C or more, more preferably from 310°C to 400°C, still more preferably from 320°C to 380°C, particularly preferably from 330°C to 370°C. When the 5% weight loss temperature falls within such ranges, a pressure-sensitive adhesive sheet excellent in heat resistance can be obtained. In addition, in general, a RDL formation process is performed at a temperature of 250°C or less, and hence, when the 5% weight loss temperature falls within the above-mentioned ranges, an outgas from the second photothermal conversion layer in the RDL formation process reduces to alleviate an influence on the electronic part, and hence a stable process can be achieved.

The modulus of elasticity of the second photothermal conversion layer measured by a nanoindentation method is preferably 100 MPa or more, more preferably from 200 MPa to 5 GPa, still more preferably from 300 MPa to 3 GPa. When the modulus of elasticity falls within such ranges, a change in shape of the second photothermal conversion layer by the generation of the gas preferably occurs at the time of irradiation with laser light, and excellent peelability can be exhibited. The modulus of elasticity measured by the nanoindentation method refers to a modulus of elasticity determined from an applied load-indentation depth curve, which is obtained by continuously measuring a load to be applied to an indenter and the indentation depth thereof when the indenter is indented into the sample over a time period from the start of loading to the end of unloading. The modulus of elasticity measured by the nanoindentation method is obtained by: perpendicularly pressing a Berkovich (triangular pyramid-shaped) probe made of diamond against a layer surface to be measured; and subjecting the thus obtained displacement-load hysteresis curve to numerical processing with software (TriboScan) included with a measurement apparatus. As used herein, the term "modulus of elasticity measured by a nanoindentation method" refers to a modulus of elasticity measured with a nanoindenter (Triboindenter TI-950 manufactured by Hysitron, Inc.) by a single indentation method at a predetermined temperature (25°C) under the measurement conditions of an indentation speed of about 500 nm/sec, a drawing speed of about 500 nm/sec, and an indentation depth of about 100 nm. The modulus of elasticity of the second photothermal conversion layer may be adjusted on the basis of, for example, the kind of a material contained in the layer, the structure of a base polymer for forming the material, and the kind and amount of an additive added to the layer.

In one embodiment, the second photothermal conversion layer contains a near infrared ray absorber. In one embodiment, the second photothermal conversion layer may be a layer in a state in which the near infrared ray absorber is incorporated in a resin. The second photothermal conversion layer may be a resin film. The resin film may be, for example, a film (e.g., a monolayer film) in a state in which the near infrared ray absorber is incorporated in a resin, or may be a film formed of a layer (e.g., a printed layer) containing a predetermined near infrared ray absorber and a resin layer.

Any appropriate near infrared ray absorber is used as the near infrared ray absorber in any appropriate blending amount as long as near infrared ray absorbability can be imparted and the effect of the present invention can be obtained. For example, cesium tungsten oxide, lanthanum hexaboride, tin-doped indium oxide, antimony-doped tin oxide, a cyanine compound, a phthalocyanine compound, a dithiol metal complex, a naphthoquinone compound, a diimmonium compound, or an azo compound is used as the near infrared ray absorber. Of those, cesium tungsten oxide or lanthanum hexaboride is preferred, and cesium tungsten oxide is more preferred. When such near infrared ray absorber is used, there can be formed a second photothermal conversion layer that is also excellent in transparency of visible light while being able to absorb a near infrared ray to generate heat.

A substance containing a tungsten element is preferably used as the near infrared ray absorber. A preferred example of the substance containing a tungsten element is cesium tungsten oxide.

A substance containing a cesium element is preferably used as the near infrared ray absorber. A preferred example of the substance containing a cesium element is cesium tungsten oxide.

When the second photothermal conversion layer contains the resin and the near infrared ray absorber, the content of the near infrared ray absorber is preferably from 1 part by weight to 50 parts by weight, more preferably from 3 parts by weight to 40 parts by weight, still more preferably from 5 parts by weight to 30 parts by weight with respect to 100 parts by weight of the resin. When the content falls within such ranges, a second photothermal conversion layer that may preferably absorb IR laser light can be formed.

Any appropriate resin may be used as the resin for forming the second photothermal conversion layer. Examples of the resin for forming the second photothermal conversion layer include an acrylic resin, an epoxy-based resin, a polyester-based resin, a polystyrene-based resin, a polyimide-based resin, and a polyurethane-based resin. Of those, an acrylic resin is preferred.

The second photothermal conversion layer preferably includes a cured product of a curable (e.g., active energy ray-curable or thermosetting) resin composition, more preferably includes a cured product of an active energy ray-curable resin composition, and still more preferably includes a cured product of an acrylic active energy ray-curable resin composition. According to the second photothermal conversion layer formed of the cured product of the curable resin composition, there is an advantage in that the second photothermal conversion layer is excellent in heat resistance. In one embodiment, the second photothermal conversion layer formed as a cured product of the curable resin composition contains a polymerization initiator. The polymerization initiator is, for example, a photopolymerization initiator or a thermal polymerization initiator. The near infrared ray absorber may be incorporated in the curable resin composition. In one embodiment, the curable resin composition contains a pentaerythritol-based polyfunctional (meth)acrylate. When the pentaerythritol-based polyfunctional (meth)acrylate is used, a second photothermal conversion layer excellent in heat resistance can be formed.

In one embodiment, an active energy ray-curable resin composition (A1), which contains a base polymer serving as a parent agent (alternatively, a monomer or an oligomer for forming the base polymer) and an active energy ray-reactive compound (monomer or oligomer), is used as the active energy ray-curable resin composition. In another embodiment, an active energy ray-curable resin composition (A2) containing an active energy ray-reactive polymer as a base polymer is used. In one embodiment, the base polymer preferably has a functional group that may be cleaved by a photopolymerization initiator. An example of the functional group is a functional group having a carbon-carbon double bond. Examples of the active energy ray include a gamma ray, UV light, visible light, an infrared ray (heat ray), a radio wave, an alpha ray, a beta ray, an electron beam, a plasma flow, an ionizing ray, and a particle beam. Of those, UV light is preferred.

Examples of the base polymer to be used in the resin composition (A1) include: rubber-based polymers, such as a natural rubber, a polyisobutylene rubber, a styrene-butadiene rubber, a styrene-isoprene-styrene block copolymer rubber, a reclaimed rubber, a butyl rubber, a polyisobutylene rubber, and a nitrile rubber (NBR); silicone-based polymers; and acrylic polymers. Those polymers may be used alone or in combination thereof. Of those, an acrylic polymer is preferred.

Examples of the acrylic polymer include: homopolymers or copolymers of (meth)acrylic acid esters, such as a (meth)acrylic acid alkyl ester, a (meth)acrylic acid cycloalkyl ester, and a (meth)acrylic acid aryl ester; and copolymers of the (meth)acrylic acid esters and other copolymerizable monomers. Specific examples of the (meth)acrylic acid alkyl ester include (meth)acrylic acid C1-20 alkyl esters, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. Of those, a (meth)acrylic acid alkyl ester having a linear or branched alkyl group having 4 to 18 carbon atoms may be preferably used.

Examples of the other copolymerizable monomer include functional group-containing monomers, such as a carboxy group-containing monomer, an acid anhydride monomer, a hydroxy group-containing monomer, a glycidyl group-containing monomer, a sulfonic acid group-containing monomer, a phosphoric acid group-containing monomer, an acrylamide, and acrylonitrile. Examples of the carboxy group-containing monomer include acrylic acid, methacrylic acid, carboxyethyl (meth)acrylate, carboxypentyl (meth)acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate. Examples of the glycidyl group-containing monomer include glycidyl (meth)acrylate and methylglycidyl (meth)acrylate. Examples of the sulfonic acid group-containing monomer include styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid. An example of the phosphoric acid group-containing monomer is 2-hydroxyethylacryloyl phosphate. An example of the acrylamide is N-acryloylmorpholine. Those monomers may be used alone or in combination thereof. The content of a constituent unit derived from the copolymerizable monomer is preferably 60 parts by weight or less, more preferably 40 parts by weight or less with respect to 100 parts by weight of the base polymer (acrylic polymer).

In one embodiment, as a monomer for forming the acrylic polymer, there is used an acrylic monomer that has a glass transition temperature of 40°C or more when turned into a homopolymer. That is, the acrylic polymer contains a constituent unit derived from the acrylic monomer that has a glass transition temperature of 40°C or more when turned into a homopolymer. Examples of such acrylic monomer include methyl methacrylate, glycidyl methacrylate, isobutyl methacrylate, acrylonitrile, methacrylonitrile, isopropyl acrylamide, acryloylmorpholine, and isobornyl acrylate. Of those, methyl methacrylate is preferred. When an acrylic polymer containing a constituent unit derived from such monomer is used, stickiness resulting from a product decomposed by irradiation with laser light can be prevented. The content of the constituent unit derived from the acrylic monomer that has a glass transition temperature of 40°C or more when turned into a homopolymer is preferably from 30 parts by weight to 80 parts by weight, more preferably from 40 parts by weight to 75 parts by weight with respect to 100 parts by weight of the base polymer (acrylic polymer). When the content falls within such ranges, the effect becomes significant.

The acrylic polymer may contain a constituent unit derived from a polyfunctional monomer. When the polyfunctional monomer is used, a second photothermal conversion layer excellent in heat resistance can be formed. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylate (i.e., polyglycidyl (meth)acrylate), polyester (meth)acrylate, and urethane (meth)acrylate. Those monomers may be used alone or in combination thereof. When the acrylic polymer includes the constituent unit derived from the polyfunctional monomer, the content of the constituent unit derived from the polyfunctional monomer is preferably 30 parts by weight or more, more preferably 40 parts by weight or more with respect to 100 parts by weight of the base polymer (acrylic polymer). The upper limit of the content of the constituent unit derived from the polyfunctional monomer is preferably 400 parts by weight or less, more preferably 300 parts by weight or less with respect to 100 parts by weight of the base polymer (acrylic polymer).

The weight-average molecular weight of the acrylic polymer is preferably from 10,000 to 1,500,000, more preferably from 20,000 to 1,000,000. The weight-average molecular weight may be measured by GPC (solvent: THF).

The active energy ray-reactive compound that may be used in the resin composition (A1) is, for example, a photoreactive monomer or oligomer having a functional group having a polymerizable carbon-carbon multiple bond, such as an acryloyl group, a methacryloyl group, a vinyl group, an allyl group, or an acetylene group. Specific examples of the photoreactive monomer include: esterified products of (meth)acrylic acid and polyhydric alcohols, such as trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, 1,4-butanediol di(meth)acrylate, 1,6-hexanediol di(meth)acrylate, and polyethylene glycol di(meth)acrylate; polyfunctional urethane (meth)acrylates; epoxy (meth)acrylates; and oligoester (meth)acrylates. In addition, a monomer, such as methacryloisocyanate, 2-methacryloyloxyethyl isocyanate (2-isocyanatoethyl methacrylate), or m-isopropenyl-α,α-dimethylbenzyl isocyanate, may be used. Specific examples of the photoreactive oligomer include dimers to pentamers of the above-mentioned monomers. The molecular weight of the photoreactive oligomer is preferably from 100 to 3,000.

In one embodiment, the active energy ray-curable resin composition (A1) contains a pentaerythritol-based polyfunctional (meth)acrylate as the active energy ray-reactive compound. The pentaerythritol-based polyfunctional (meth)acrylate may be obtained by esterifying part or whole of the hydroxy groups of pentaerythritol or a polymerized product thereof with a (meth)acrylate. When the pentaerythritol-based polyfunctional (meth)acrylate is used as the active energy ray-reactive compound, a second photothermal conversion layer excellent in heat resistance can be formed.

In addition, a monomer, such as epoxidized butadiene, glycidyl methacrylate, acrylamide, or a vinylsiloxane, or an oligomer including the monomer may be used as the active energy ray-reactive compound.

The content of the active energy ray-reactive compound in the resin composition (A1) is preferably from 0.1 part by weight to 500 parts by weight, more preferably from 5 parts by weight to 300 parts by weight, still more preferably from 40 parts by weight to 150 parts by weight with respect to 100 parts by weight of the base polymer.

The active energy ray-reactive polymer (base polymer) in the resin composition (A2) is, for example, a polymer having a functional group having a carbon-carbon multiple bond, such as an acryloyl group, a methacryloyl group, a vinyl group, an allyl group, or an acetylene group. Specific examples of the active energy ray-reactive polymer include: polymers including polyfunctional (meth)acrylates (e.g., polymers each including a constituent unit derived from a polyfunctional monomer); photocationically polymerizable polymers; cinnamoyl group-containing polymers such as polyvinyl cinnamate; diazotized amino novolac resins; and polyacrylamide.

In one embodiment, there is used an active energy ray-reactive polymer formed by introducing an active energy ray-polymerizable carbon-carbon multiple bond into a side chain of the acrylic polymer, a main chain thereof, and/or a terminal of the main chain. An approach to introducing a radiation-polymerizable carbon-carbon double bond into the acrylic polymer is, for example, a method including: copolymerizing raw material monomers including a monomer having a predetermined functional group (first functional group) to provide the acrylic polymer; and then subjecting a compound having a predetermined functional group (second functional group) that can react with the first functional group to be bonded thereto and the radiation-polymerizable carbon-carbon double bond to a condensation reaction or an addition reaction with the acrylic polymer while maintaining the radiation polymerizability of the carbon-carbon double bond.

Examples of the combination of the first functional group and the second functional group include: a carboxy group and an epoxy group; an epoxy group and a carboxy group; a carboxy group and an aziridyl group; an aziridyl group and a carboxy group; a hydroxy group and an isocyanate group; and an isocyanate group and a hydroxy group. Of those combinations, the combination of a hydroxy group and an isocyanate group or the combination of an isocyanate group and a hydroxy group is preferred from the viewpoint of the ease with which a reaction between the groups is tracked. In addition, technical difficulty in producing a polymer having an isocyanate group having high reactivity is high, and hence a case in which the first functional group of the acrylic polymer side is a hydroxy group and the second functional group is an isocyanate group is more preferred from the viewpoint of the ease with which the acrylic polymer is produced or obtained. In this case, examples of an isocyanate compound having both of a radiation-polymerizable carbon-carbon double bond and an isocyanate group serving as the second functional group include methacryloyl isocyanate, 2-methacryloyloxyethyl isocyanate, and m-isopropenyl-α,α-dimethylbenzyl isocyanate. In addition, a polymer containing a constituent unit derived from the above-mentioned hydroxy group-containing monomer is preferred as the acrylic polymer having the first functional group, and a polymer containing a constituent unit derived from an ether-based compound, such as 2-hydroxyethyl vinyl ether, 4-hydroxybutyl vinyl ether, or diethylene glycol monovinyl ether, is also preferred.

The resin composition (A2) may further contain the active energy ray-reactive compound (monomer or oligomer).

In one embodiment, the active energy ray-curable resin composition contains a polymerization initiator. As the polymerization initiator, for example, a photopolymerization initiator or a thermal polymerization initiator may be used. Of those, a photopolymerization initiator is preferred.

Any appropriate initiator may be used as the photopolymerization initiator. Examples of the photopolymerization initiator include: α-ketol-based compounds, such as 4-(2-hydroxyethoxy)phenyl(2-hydroxy-2-propyl) ketone, α-hydroxy-α,α'-dimethylacetophenone, 2-methyl-2-hydroxypropiophenone, and 1-hydroxycyclohexyl phenyl ketone; acetophenone-based compounds, such as methoxyacetophenone, 2,2-dimethoxy-2-phenylacetophenone, 2,2-diethoxyacetophenone, and 2-methyl-1-[4-(methylthio)-phenyl]-2-morpholinopropane-l; benzoin ether-based compounds, such as benzoin ethyl ether, benzoin isopropyl ether, and anisoin methyl ether; ketal-based compounds such as benzyl dimethyl ketal; aromatic sulfonyl chloride-based compounds such as 2-naphthalenesulfonyl chloride; photoactive oxime-based compounds such as 1-phenone-1,1-propanedione-2-(o-ethoxycarbonyl)oxime; benzophenone-based compounds, such as benzophenone, benzoylbenzoic acid, and 3,3'-dimethyl-4-methoxybenzophenone; thioxanthone-based compounds, such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; acylphosphinoxides; and acylphosphonates. The usage amount of the photopolymerization initiator may be set to any appropriate amount.

In one embodiment, the active energy ray-curable resin composition may contain a photosensitizer.

The active energy ray-curable resin composition preferably contains a cross-linking agent. Examples of the cross-linking agent include an isocyanate-based cross-linking agent, an epoxy-based cross-linking agent, an oxazoline-based cross-linking agent, an aziridine-based cross-linking agent, a melamine-based cross-linking agent, a peroxide-based cross-linking agent, a urea-based cross-linking agent, a metal alkoxide-based cross-linking agent, a metal chelate-based cross-linking agent, a metal salt-based cross-linking agent, a carbodiimide-based cross-linking agent, and an amine-based cross-linking agent.

The content of the cross-linking agent is preferably from 0.01 part by weight to 20 parts by weight with respect to 100 parts by weight of the base polymer of the resin composition.

In one embodiment, an epoxy-based cross-linking agent is preferably used. When the epoxy-based cross-linking agent is used, a thermal decomposition layer having a high 5% weight loss temperature after UV irradiation can be formed. Examples of the epoxy-based cross-linking agent include N,N,N',N'-tetraglycidyl-m-xylenediamine, diglycidylaniline, 1,3-bis(N,N-glycidylaminomethyl)cyclohexane (manufactured by Mitsubishi Gas Chemical Company, Inc., product name: "TETRAD-C"), 1,6-hexanediol diglycidyl ether (manufactured by Kyoeisha Chemical Co., Ltd., product name: "Epolight 1600"), neopentyl glycol diglycidyl ether (manufactured by Kyoeisha Chemical Co., Ltd., product name: "Epolight 1500NP"), ethylene glycol diglycidyl ether (manufactured by Kyoeisha Chemical Co., Ltd., product name: "Epolight 40E"), propylene glycol diglycidyl ether (manufactured by Kyoeisha Chemical Co., Ltd., product name: "Epolight 70P"), polyethylene glycol diglycidyl ether (manufactured by NOF Corporation, product name: "EPIOL E-400"), polypropylene glycol diglycidyl ether (manufactured by NOF Corporation, product name: "EPIOL P-200"), sorbitol polyglycidyl ether (manufactured by Nagase ChemteX Corporation, product name: "Denacol EX-611"), glycerol polyglycidyl ether (manufactured by Nagase ChemteX Corporation, product name: "Denacol EX-314"), pentaerythritol polyglycidyl ether, polyglycerol polyglycidyl ether (manufactured by Nagase ChemteX Corporation, product name: "Denacol EX-512"), sorbitan polyglycidyl ether, trimethylolpropane polyglycidyl ether, adipic acid diglycidyl ester, o-phthalic acid diglycidyl ester, triglycidyl-tris(2-hydroxyethyl)isocyanurate, resorcin diglycidyl ether, bisphenol-S-diglycidyl ether, and an epoxy-based resin having two or more epoxy groups in a molecule thereof. The content of the epoxy-based cross-linking agent may be set to any appropriate amount in accordance with desired characteristics, and is typically from 0.01 part by weight to 10 parts by weight, more preferably from 0.05 part by weight to 7 parts by weight with respect to 100 parts by weight of the base polymer.

In one embodiment, an isocyanate-based cross-linking agent is preferably used. Specific examples of the isocyanate-based cross-linking agent include: lower aliphatic polyisocyanates, such as butylene diisocyanate and hexamethylene diisocyanate; alicyclic isocyanates, such as cyclopentylene diisocyanate, cyclohexylene diisocyanate, and isophorone diisocyanate; aromatic isocyanates, such as 2,4-tolylene diisocyanate, 4,4'-diphenylmethane diisocyanate, and xylylene diisocyanate; and isocyanate adducts, such as a trimethylolpropane/tolylene diisocyanate trimer adduct (manufactured by Nippon Polyurethane Industry Co., Ltd., product name: "CORONATE L"), a trimethylolpropane/hexamethylene diisocyanate trimer adduct (manufactured by Nippon Polyurethane Industry Co., Ltd., product name: "CORONATE HL"), and an isocyanurate form of hexamethylene diisocyanate (manufactured by Nippon Polyurethane Industry Co., Ltd., product name: "CORONATE HX") . Of those, a cross-linking agent having 3 or more isocyanate groups is preferably used. The content of the isocyanate-based cross-linking agent may be set to any appropriate amount in accordance with desired characteristics, and is typically from 0.1 part by weight to 20 parts by weight, more preferably from 0.5 part by weight to 10 parts by weight with respect to 100 parts by weight of the base polymer.

The active energy ray-curable resin composition may further contain any appropriate additive as required. Examples of the additive include an active energy ray polymerization accelerator, a radical scavenger, a tackifier, a plasticizer (e.g., a trimellitate-based plasticizer or a pyromellitate-based plasticizer), a pigment, a dye, a filler, an age resistor, a conductive material, an antistatic agent, a UV absorber, a light stabilizer, a peeling modifier, a softener, a surfactant, a flame retardant, and an antioxidant.

### (Method of forming Photothermal Conversion Layer)

The photothermal conversion layer may be produced by any appropriate method. The method of forming the photothermal conversion layer includes, for example, a step (A) of preparing a composition for forming a second photothermal conversion layer, a step (B) of applying the composition for forming a second photothermal conversion layer to the above-mentioned first photothermal conversion layer, and a step (C) of curing an application layer of the composition for forming a second photothermal conversion layer.

The composition for forming a second photothermal conversion layer contains a near infrared ray absorber. In one embodiment, the composition for forming a second photothermal conversion layer may be the above-mentioned curable resin composition (preferably the above-mentioned active energy ray-curable resin composition) containing the near infrared ray absorber. In one embodiment, a substance containing a tungsten element and/or a substance containing a cesium element is used as the near infrared ray absorber. That is, in one embodiment, the composition for forming a second photothermal conversion layer contains the substance containing a tungsten element and/or the substance containing a cesium element.

Any appropriate method may be adopted as a method of applying the composition for forming a second photothermal conversion layer. Examples of the method of applying the composition for forming a second photothermal conversion layer include bar coater coating, air knife coating, gravure coating, gravure reverse coating, reverse roll coating, lip coating, die coating, dip coating, offset printing, flexographic printing, and screen printing.

When the composition for forming a second photothermal conversion layer contains the active energy ray-reactive compound, in the step (C), an application layer of the composition for forming a second photothermal conversion layer is irradiated with an active energy ray such as UV light. Conditions for the irradiation may be set to any appropriate conditions in accordance with the composition of the composition for forming a second photothermal conversion layer.

When the composition for forming a second photothermal conversion layer has a thermosetting property, heating treatment is performed in the step (C). Conditions for the heating may be set to any appropriate conditions in accordance with the composition of the composition for forming a second photothermal conversion layer.

### D. Laminated Structure A (First Photothermal Conversion Layer/Second Photothermal Conversion Layer)

The transmittance of the laminated structure A including the first photothermal conversion layer and the second photothermal conversion layer for light having a wavelength of 1,032 nm is preferably 75% or less, more preferably 65% or less, still more preferably 50% or less, still more preferably 40% or less, particularly preferably 30% or less, most preferably 20% or less. When the transmittance falls within such ranges, a pressure-sensitive adhesive sheet that may preferably absorb IR laser light can be obtained.

The transmittance of the laminated structure A for light having a wavelength of 600 nm is preferably 50% or more, more preferably 60% or more, still more preferably 70% or more, particularly preferably 80% or more. The upper limit of the transmittance for light having a wavelength of 600 nm is, for example, 90% (preferably 95%). According to a pressure-sensitive adhesive sheet including such laminated structure A, there is an advantage not only in that the pressure-sensitive adhesive sheet may absorb the IR laser light to generate heat, but also in that the pressure-sensitive adhesive sheet is excellent in visibility through the pressure-sensitive adhesive sheet.

In one embodiment, the transmittance of the laminated structure A for light having a wavelength of 355 nm is 50% or less, preferably 40% or less, more preferably 20% or less, particularly preferably 10% or less, most preferably 0%. The adjustment of the transmittance of the first photothermal conversion layer for light having a wavelength of 355 nm and the setting of the transmittance of the laminated structure A for light having a wavelength of 355 nm within such ranges enable the heat generation of the first photothermal conversion layer by UV laser light, and hence a pressure-sensitive adhesive sheet that can also exhibit peelability by UV laser light can be obtained.

The thickness of the laminated structure A is preferably from 10 µm to 200 µm, more preferably from 20 µm to 150 µm.

### E. Pressure-sensitive Adhesive Layer

The pressure-sensitive adhesive layer contains any appropriate pressure-sensitive adhesive. For example, the pressure-sensitive adhesive layer contains a pressure-sensitive adhesive having pressure sensitivity or a curable pressure-sensitive adhesive. The above-mentioned active energy ray-curable resin composition may be used as the curable pressure-sensitive adhesive. The pressure-sensitive adhesive layer may be formed through the application of the pressure-sensitive adhesive to the laminated structure A (first photothermal conversion layer/second photothermal conversion layer) by any appropriate method.

Examples of the pressure-sensitive adhesive include an acrylic pressure-sensitive adhesive, a silicone-based pressure-sensitive adhesive, an epoxy-based pressure-sensitive adhesive, a styrene-based thermoplastic elastomer, and an ester-based pressure-sensitive adhesive. In one embodiment, an acrylic pressure-sensitive adhesive is used. Now, an example of the acrylic pressure-sensitive adhesive is described.

### (Base Polymer)

The acrylic pressure-sensitive adhesive is, for example, an acrylic pressure-sensitive adhesive obtained by using an acrylic polymer (homopolymer or copolymer), which uses one kind or two or more kinds of (meth)acrylic acid alkyl esters as monomer components, as a base polymer. Specific examples of the (meth)acrylic acid alkyl ester include (meth)acrylic acid C1-20 alkyl esters, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. Of those, a (meth)acrylic acid alkyl ester having a linear or branched alkyl group having 4 to 18 carbon atoms may be preferably used. The content of the constituent unit of the (meth) acrylic acid alkyl ester in the acrylic polymer is preferably from 70 parts by weight to 100 parts by weight, more preferably from 75 parts by weight to 99.9 parts by weight, still more preferably from 80 parts by weight to 99.9 parts by weight with respect to 100 parts by weight of the acrylic polymer.

The acrylic polymer may contain a constituent unit derived from any other monomer copolymerizable with the (meth)acrylic acid alkyl ester as required for the purpose of modification of cohesive strength, heat resistance, or cross-linkability, an improvement in dimensional stability of the pressure-sensitive adhesive layer, or the like. Examples of such monomer include the following monomers:
carboxy group-containing monomers including: ethylenically unsaturated monocarboxylic acids, such as acrylic acid (AA), methacrylic acid (MAA), and crotonic acid; and ethylenically unsaturated dicarboxylic acids, such as maleic acid, itaconic acid, and citraconic acid, and anhydrides thereof (such as maleic anhydride and itaconic anhydride);
hydroxy group-containing monomers including: hydroxyalkyl (meth)acrylates, such as 2-hydroxyethyl (meth)acrylate, 2-hydroxypropyl (meth)acrylate, 3-hydroxypropyl (meth)acrylate, and 2-hydroxybutyl (meth)acrylate; unsaturated alcohols, such as vinyl alcohol and allyl alcohol; and ether-based compounds, such as 2-hydroxyethyl vinyl ether, 4-hydroxybutyl vinyl ether, and diethylene glycol monovinyl ether;
amino group-containing monomers including aminoethyl (meth)acrylate, N,N-dimethylaminoethyl (meth)acrylate, and t-butylaminoethyl (meth)acrylate;
epoxy group-containing monomers including glycidyl (meth)acrylate, methylglycidyl (meth)acrylate, and allyl glycidyl ether;
cyano group-containing monomers including acrylonitrile and methacrylonitrile;
keto group-containing monomers including diacetone (meth)acrylamide, diacetone (meth)acrylate, vinyl methyl ketone, vinyl ethyl ketone, allyl acetoacetate, and vinyl acetoacetate;
monomers each having a nitrogen atom-containing ring including N-vinyl-2-pyrrolidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-vinylmorpholine, N-vinylcaprolactam, and N-(meth)acryloylmorpholine;
alkoxysilyl group-containing monomers including 3-(meth)acryloxypropyltrimethoxysilane, 3-(meth)acryloxypropyltriethoxysilane, 3-(meth)acryloxypropylmethyldimethoxysilane, and 3-(meth)acryloxypropylmethyldiethoxysilane; and
isocyanate group-containing monomers including (meth)acryloyl isocyanate, 2-(meth)acryloyloxyethyl isocyanate, and m-isopropenyl-α,α-dimethylbenzyl isocyanate.

Those monomers may be used alone or in combination thereof.

The weight-average molecular weight of the acrylic polymer is preferably from 600,000 to 1,600,000, more preferably from 800,000 to 1,500,000. When the weight-average molecular weight falls within such ranges, there can be formed a pressure-sensitive adhesive layer, which has excellent heat resistance and excellent dimensional stability under high temperature, and is suppressed in occurrence of outgassing by heating. The weight-average molecular weight may be measured by GPC (solvent: THF).

### (Additive)

The acrylic pressure-sensitive adhesive may contain any appropriate additive as required. Examples of the additive include a cross-linking agent, a cross-linking catalyst, a tackifier, a plasticizer, a pigment, a dye, a filler, an age resistor, a conductive material, an antistatic agent, a UV absorber, a light stabilizer, a peeling modifier, a softener, a surfactant, a flame retardant, and an antioxidant.

Examples of the cross-linking agent include an isocyanate-based cross-linking agent, an epoxy-based cross-linking agent, a melamine-based cross-linking agent, a peroxide-based cross-linking agent, a urea-based cross-linking agent, a metal alkoxide-based cross-linking agent, a metal chelate-based cross-linking agent, a metal salt-based cross-linking agent, a carbodiimide-based cross-linking agent, an oxazoline-based cross-linking agent, an aziridine-based cross-linking agent, and an amine-based cross-linking agent. Of those, an epoxy-based cross-linking agent or an isocyanate-based cross-linking agent is preferred.

Examples of the epoxy-based cross-linking agent include N,N,N',N'-tetraglycidyl-m-xylenediamine, diglycidylaniline, 1,3-bis(N,N-glycidylaminomethyl)cyclohexane (manufactured by Mitsubishi Gas Chemical Company, Inc., product name: "TETRAD-C"), 1,6-hexanediol diglycidyl ether (manufactured by Kyoeisha Chemical Co., Ltd., product name: "Epolight 1600"), neopentyl glycol diglycidyl ether (manufactured by Kyoeisha Chemical Co., Ltd., product name: "Epolight 1500NP"), ethylene glycol diglycidyl ether (manufactured by Kyoeisha Chemical Co., Ltd., product name: "Epolight 40E"), propylene glycol diglycidyl ether (manufactured by Kyoeisha Chemical Co., Ltd., product name: "Epolight 70P"), polyethylene glycol diglycidyl ether (manufactured by NOF Corporation, product name: "EPIOL E-400"), polypropylene glycol diglycidyl ether (manufactured by NOF Corporation, product name: "EPIOL P-200"), sorbitol polyglycidyl ether (manufactured by Nagase ChemteX Corporation, product name: "Denacol EX-611"), glycerol polyglycidyl ether (manufactured by Nagase ChemteX Corporation, product name: "Denacol EX-314"), pentaerythritol polyglycidyl ether, polyglycerol polyglycidyl ether (manufactured by Nagase ChemteX Corporation, product name: "Denacol EX-512") , sorbitan polyglycidyl ether, trimethylolpropane polyglycidyl ether, adipic acid diglycidyl ester, o-phthalic acid diglycidyl ester, triglycidyl-tris(2-hydroxyethyl) isocyanurate, resorcin diglycidyl ether, bisphenol-S-diglycidyl ether, and an epoxy-based resin having two or more epoxy groups in a molecule thereof. The content of the epoxy-based cross-linking agent may be set to any appropriate amount in accordance with a desired pressure-sensitive adhesive strength, and the viscoelasticity, dimensional stability, and outgassing property of the pressure-sensitive adhesive layer, and is typically from 0.01 part by weight to 10 parts by weight, more preferably from 0.03 part by weight to 7 parts by weight with respect to 100 parts by weight of the base polymer.

Specific examples of the isocyanate-based cross-linking agent include: lower aliphatic polyisocyanates, such as butylene diisocyanate and hexamethylene diisocyanate; alicyclic isocyanates, such as cyclopentylene diisocyanate, cyclohexylene diisocyanate, and isophorone diisocyanate; aromatic isocyanates, such as 2,4-tolylene diisocyanate, 4,4'-diphenylmethane diisocyanate, and xylylene diisocyanate; and isocyanate adducts, such as a trimethylolpropane/tolylene diisocyanate trimer adduct (manufactured by Nippon Polyurethane Industry Co., Ltd., product name: "CORONATE L"), a trimethylolpropane/hexamethylene diisocyanate trimer adduct (manufactured by Nippon Polyurethane Industry Co., Ltd., product name: "CORONATE HL"), and an isocyanurate form of hexamethylene diisocyanate (manufactured by Nippon Polyurethane Industry Co., Ltd., product name: "CORONATE HX"). The content of the isocyanate-based cross-linking agent may be set to any appropriate amount in accordance with a desired pressure-sensitive adhesive strength, the elasticity, dimensional stability, and outgassing property of the pressure-sensitive adhesive layer, and the like, and is typically from 0.1 part by weight to 20 parts by weight, more preferably from 0.5 part by weight to 10 parts by weight with respect to 100 parts by weight of the base polymer.

In one embodiment, a heat-resistant pressure-sensitive adhesive is used as the pressure-sensitive adhesive in the pressure-sensitive adhesive layer. When the pressure-sensitive adhesive sheet includes the pressure-sensitive adhesive layer including the heat-resistant pressure-sensitive adhesive, scorching (adhesive residue) on an optically transparent support substrate can be suppressed when the sheet is irradiated with laser light. Herein, the heat-resistant pressure-sensitive adhesive means a pressure-sensitive adhesive having a predetermined pressure-sensitive adhesive strength under an environment at 260°C. The heat-resistant pressure-sensitive adhesive may be preferably used without causing an adhesive residue under an environment at 260°C. The heat-resistant pressure-sensitive adhesive preferably contains, for example, an acrylic resin or a silicone-based resin as the base polymer.

The thickness of the pressure-sensitive adhesive layer is preferably from 5 µm to 100 µm, more preferably from 10 µm to 50 µm.

The transmittance of the pressure-sensitive adhesive layer for light having a wavelength of 1,032 nm is preferably 75% or more, more preferably 85% or more, still more preferably 90% or more. The upper limit of the transmittance for light having a wavelength of 1,032 nm is, for example, 97% (preferably 98%).

The transmittance of the pressure-sensitive adhesive layer for light having a wavelength of 600 nm is preferably 75% or more, more preferably 85% or more, still more preferably 90% or more. The upper limit of the transmittance for light having a wavelength of 1,032 nm is, for example, 97% (preferably 98%).

The transmittance of the pressure-sensitive adhesive layer for light having a wavelength of 355 nm is preferably 75% or more, more preferably 85% or more, still more preferably 90% or more. The upper limit of the transmittance for light having a wavelength of 1,032 nm is, for example, 97% (preferably 98%).

### F. Use of Pressure-sensitive Adhesive Sheet for temporarily fixing Electronic Part

The pressure-sensitive adhesive sheet for temporarily fixing an electronic part may be used as described in the section A with reference to FIGS. **2** and FIGS. **3****.**

Examples of the electronic part serving as a workpiece include a semiconductor wafer, a semiconductor package, a semiconductor chip, an insulating material for a circuit board, a die attach film, a semiconductor sealing resin, a semiconductor protecting film, a resin composition for forming a semiconductor protecting film, a metal material, and a ceramic material. A plurality of the electronic parts may be arranged, or one of the electronic parts may be arranged.

The electronic part may be bonded to the pressure-sensitive adhesive sheet via, for example, another pressure-sensitive adhesive layer arranged on the side of the first photothermal conversion layer opposite to the second photothermal conversion layer.

A support including any appropriate material may be used as the support. For example, a support including: a glass, such as borosilicate glass or quartz glass; sapphire; or an acrylic resin, such as polymethyl methacrylate (PMMA) or polycarbonate (PC), is used. In one embodiment, a support free of an organic layer on its surface is used. The arithmetic surface roughness Ra of the support is, for example, preferably from 0.3 nm to 100 nm, more preferably from 0.4 nm to 50 nm. The arithmetic surface roughness Ra may be measured in conformity with JIS B 0601. In general, the surface roughness of the support is preferably as small as possible from the viewpoint of prevention of a residue. In addition, the support is preferably optically transparent in the range of from UV light to an infrared ray. In particular, the support is preferably optically transparent to laser light having any appropriate wavelength to be selected. The transmittance of the support at a wavelength of laser light is, for example, preferably 50% or more, more preferably 60% or more. The water contact angle of a support surface is, for example, preferably from 0° to 150°, more preferably from 3° to 120°. According to the present invention, even when a support whose satisfactory peeling has heretofore been difficult to achieve (e.g., a support causing a residue or having a poor pickup property) is used, there is an advantage in that preferred peeling is enabled, that is, the range of selection of the support is enlarged.

The electronic part may be subjected to predetermined treatment after the electronic part is arranged on the pressure-sensitive adhesive sheet (i.e., the state of FIG. 2(a)). Examples of the treatment include grinding processing, dicing processing, die bonding, wire bonding, etching, chemical cleaning, vapor deposition, molding, rewiring layer formation, through-hole formation, and protection of a device surface.

Laser light having any appropriate wavelength is used as the laser light in accordance with the configuration of the pressure-sensitive adhesive sheet. Conditions for the irradiation with the laser light may also be set to any appropriate conditions in accordance with the configuration of the pressure-sensitive adhesive sheet. In one embodiment, IR laser light is used as the laser light. The wavelength of the IR laser light is preferably 800 nm or more, more preferably from 800 nm to 1,600 nm, still more preferably from 900 nm to 1,200 nm. The output of the IR laser light is, for example, from 0.01 W to 10 W. In another embodiment, UV laser light is used as the laser light. The wavelength of the UV laser light is preferably 380 nm or less, more preferably from 150 nm to 380 nm, still more preferably from 240 nm to 360 nm. The output of the UV laser light is, for example, from 0.1 W to 2.0 W. The UV laser light may be selected when the first photothermal conversion layer may absorb the UV laser light, and when the UV laser light is applied, thermal decomposition of the second photothermal conversion layer is caused by the heat generation of the first photothermal conversion layer, and peelability is exhibited.

### Examples

Now, the present invention is specifically described by way of Examples. However, the present invention is by no means limited to these Examples. Evaluation methods in Examples are as described below. In addition, the terms "part(s)" and "%" in Examples are by weight unless otherwise stated.

### [Evaluation]

### (1) Tensile Modulus of Elasticity at 200°C of First Photothermal Conversion Layer (Base material)

The tensile modulus of elasticity at 200°C of an evaluation sample was measured with a dynamic viscoelasticity-measuring apparatus (manufactured by TA Instruments, product name: "RSA-3") under the following conditions.
Measurement frequency: 1 Hz
Strain: 0.05%
Chuck-to-chuck distance: 20 mm
Sample width: 10 mm
Rate of temperature increase from 0°C to 250°C of 5°C/min

### (2) 5% Weight Loss Temperature of each of First Photothermal Conversion Layer (Base Material), Second Photothermal Conversion Layer, and Laminated Structure A

The temperature at which the weight of a predetermined sample reduced by 5% as compared to the dry weight of the sample before the temperature increase was measured with a differential thermal analyzer (manufactured by TA Instruments, product name: "Discovery TGA") at a rate of temperature increase of 10°C/min and a flow rate of 25 ml/min under a N₂ atmosphere. The dry weight of the sample means the weight except moisture in the sample.

Specifically, about 0.01 g of the evaluation sample was set in the analyzer. An influence of moisture incorporated therein was removed by increasing the temperature from 20°C to 110°C once at the above-mentioned rate of temperature increase and then decreasing the temperature from 110°C to 20°C at a rate of temperature decrease of 10°C/min, and the dry weight was thus obtained. The weight loss of the evaluation sample was measured while its temperature was increased again from 20°C to 500°C at the above-mentioned rate of temperature increase. The temperature at which the weight loss became 5% was sampled from the obtained data.

### (3) Light Transmittances of Laminated Structure A, Pressure-Sensitive Adhesive Sheet, and Pressure-sensitive Adhesive Layer

The evaluation sample was set in a spectrophotometer (product name: "UV-VIS SPECTROPHOTOMETER SolidSpec 3700", manufactured by Shimadzu Corporation), and its light transmittance in the wavelength region of from 300 nm to 2,500 nm was measured while incident light was adapted to vertically enter each sample. Transmittances at wavelengths of 355 nm, 600 nm, and 1,032 nm in the resultant transmission spectrum were sampled.

### (4) Laser Debonding Property Evaluation by IR laser

A pressure-sensitive adhesive layer on the first photothermal conversion layer (base material) side (thickness: 10 µm) of each of the pressure-sensitive adhesive sheets was bonded to thin glass (cover glass manufactured by Matsunami Glass Ind., Ltd., Rectangular No. 1, product name: "C050701") having a width of 50 mm, a length of 70 mm, and a thickness of 0.12 mmt, the thin glass simulating a workpiece such as a semiconductor wafer, with a hand roller, and the pressure-sensitive adhesive sheet was cut in accordance with the size of the thin glass. After that, a pressure-sensitive adhesive layer on the second photothermal conversion layer side (thickness: 30 µm, transmittance for light having a wavelength of 1,032 nm: 93.91%) was laminated on a support (thick glass (large glass slide manufactured by Matsunami Glass Ind., Ltd., Standard Large White Edge Grinding No. 2, product name: "S9112") having a width of 52 mm, a length of 76 mm, and a thickness of 1.0 mmt, the thick glass simulating an optically transparent support substrate) with a hand roller. After that, the laminate was loaded in an autoclave, and was defoamed by warming (at 40°C and 5 kgf for 10 minutes) so that air bubbles trapped in the laminate were removed. Thus, a laminate sample was produced.

Laser light was applied from the support side to the produced laminate sample to perform a laser debonding property evaluation. Specifically, a pulse scan was performed with laser light having a wavelength of 1,032 nm and a beam diameter of about 200 µmϕ at an output of 8.4 W and a frequency of 25 kHz so that pitch intervals were about 60 µm longitudinally and laterally. After the application of the laser light to the laminate sample, the debonding property was evaluated by the following criteria.

The evaluation of a laser debonding property was performed as described below. In the debonding work of the thin glass and the thick glass, the level at which the debonding was able to be easily performed when one site of the outer peripheral portion of the laminate sample was lifted with a cutter blade was evaluated as a success in the debonding workability (o), the level at which the debonding was able to be performed only when the entire outer peripheral portion was lifted with a cutter blade was evaluated as (Δ), and the level at which the debonding was unable to be performed even when a cutter blade was inserted in the outer peripheral portion or cracking of the thin glass (workpiece) occurred was evaluated as a failure (×).

### (5) Laser Debonding Property Evaluation by UV Laser

A laminate sample was obtained in the same manner as in the evaluation (4).

Laser light was applied from the support side to the produced laminate sample to perform a laser debonding property evaluation. Specifically, a pulse scan was performed with line laser light having a wavelength of 355 nm, a beam width of about 10 µm, a beam length of about 1.5 mm, and an energy density of 0.5 J/cm² at an output of 0.75 W and a frequency of 10 kHz so that overlapping of intervals of the centers of lines occurred for about 10 µm in a widthwise direction and about 0.2 mm or more in a lengthwise direction.

### (6) Chemical Resistance

0.1 Milliliters of N-methyl-2-pyrrolidone (manufactured by Kishida Chemical Co., Ltd.) was dropped on a second photothermal conversion layer. After that, the resultant was left at 25°C for 15 minutes, and then the N-methyl-2-pyrrolidone (manufactured by Kishida Chemical Co., Ltd.) was wiped off, and chemical resistance was evaluated by the presence or absence of peeling of the second photothermal conversion layer. In the table, a case in which no peeling was present was regarded as a success (∘), and a case in which peeling was present was regarded as a failure (×).

### (7) Visibility

Visibility through each of the pressure-sensitive adhesive sheets was evaluated. Specifically, the visibility was evaluated by evaluating whether or not a chip was visible through the pressure-sensitive adhesive sheet under a fluorescent light. A case in which the chip was able to be viewed was regarded as a success (∘), and a case in which the chip was not able to be viewed was regarded as a failure (×).

### [Production Example 1] Composition A for forming Second Photothermal Conversion Layer

50 Parts by weight of an acrylic polymer having a weight-average molecular weight (Mw) of about 22,000 obtained by copolymerizing methyl methacrylate and an acryloyl-modified glycerin methacrylate at 50:50 (molar ratio), 50 parts by weight of a pentaerythritol-based polyfunctional acrylate, methyl isobutyl ketone, 0.5 part by weight of a photopolymerization initiator (manufactured by BASF SE, product name: "Omnirad 127D"), 15 parts by weight of a near infrared ray absorber (cesium tungsten oxide dispersion liquid, product name: "YMF-02A", manufactured by Sumitomo Metal Mining Co., Ltd.), and ethyl acetate were mixed to prepare a composition A for forming a photothermal conversion layer.

### [Production Example 2] Composition B for forming Second Photothermal Conversion Layer

A composition B for forming a second photothermal conversion layer was prepared in the same manner as in Production Example 1 except that the blending amount of the infrared ray absorber (cesium tungsten oxide dispersion liquid, product name: "YMF-02A", manufactured by Sumitomo Metal Mining Co., Ltd.) was set to 7.5 parts by weight.

### [Production Example 3] Composition C for forming Second Photothermal Conversion Layer

A composition C for forming a second photothermal conversion layer was prepared in the same manner as in Production Example 1 except that the blending amount of the infrared ray absorber (cesium tungsten oxide dispersion liquid, product name: "YMF-02A", manufactured by Sumitomo Metal Mining Co., Ltd.) was set to 23 parts by weight.

### [Production Example 4] Composition D for forming Second Photothermal Conversion Layer

50 Parts by weight of an acrylic polymer having a weight-average molecular weight (Mw) of about 22,000, which had been obtained by copolymerizing methyl methacrylate and an acryloyl-modified glycerin methacrylate at 50:50 (molar ratio), 50 parts by weight of a pentaerythritol-based polyfunctional acrylate, methyl isobutyl ketone, 10 parts by weight of an acrylic polymer having a weight-average molecular weight (Mw) of about 29,000, which had been obtained by copolymerizing methyl methacrylate and an acryloyl-modified glycerin methacrylate at 71:29 (molar ratio), butyl acetate, 0.5 part by weight of a photopolymerization initiator (manufactured by BASF SE, product name: "Omnirad 127D"), 15 parts by weight of a near infrared ray absorber (cesium tungsten oxide dispersion liquid, product name: "YMF-02A", manufactured by Sumitomo Metal Mining Co., Ltd.), and ethyl acetate were mixed to prepare a composition D for forming a photothermal conversion layer.

### [Production Example 5] Composition E for forming Second Photothermal Conversion Layer

A composition E for forming a photothermal conversion layer was prepared in the same manner as in Production Example 4 except that the blending amount of the "acrylic polymer having a weight-average molecular weight (Mw) of about 29,000, which had been obtained by copolymerizing methyl methacrylate and an acryloyl-modified glycerin methacrylate at 71:29 (molar ratio)" was set to 40 parts by weight.

### [Production Example 6] Composition F for forming Second Photothermal Conversion Layer

100 Parts by weight of an acrylic polymer having a weight-average molecular weight (Mw) of about 29,000, which had been obtained by copolymerizing methyl methacrylate and an acryloyl-modified glycerin methacrylate at 71:29 (molar ratio), butyl acetate, 0.5 part by weight of a photopolymerization initiator (manufactured by BASF SE, product name: "Omnirad 127D"), 15 parts by weight of a near infrared ray absorber (cesium tungsten oxide dispersion liquid, product name: "YMF-02A", manufactured by Sumitomo Metal Mining Co., Ltd.), and ethyl acetate were mixed to prepare a composition F for forming a photothermal conversion layer.

### [Production Example 7] Composition G for forming Second Photothermal Conversion Layer

A composition G for forming a second photothermal conversion layer was prepared in the same manner as in Production Example 1 except that the blending amount of the infrared ray absorber (cesium tungsten oxide dispersion liquid, product name: "YMF-02A", manufactured by Sumitomo Metal Mining Co., Ltd.) was set to 4 parts by weight.

### [Example 1]

The composition A for forming a second photothermal conversion layer obtained in Production Example 1 was applied to one side of a polyimide film (manufactured by Du Pont-Toray Co., Ltd., product name: "Kapton 100H", thickness: 25 µm) so as to have a thickness of 2 µm after solvent volatilization (drying), and was then dried to form a second photothermal conversion layer on the polyimide film. The resultant was bonded to a polyethylene terephthalate film with a silicone release agent-treated surface (manufactured by Toray Industries, Inc., product name: "Cerapeel", thickness: 38 µm) through lamination between rolls. The resultant was subjected to UV irradiation from its polyethylene terephthalate film with a silicone release agent-treated surface side under the condition of an integrated light quantity of 1,380 mJ/cm². After that, the polyethylene terephthalate film with a silicone release agent-treated surface was peeled. Thus, a laminate (second photothermal conversion layer/first photothermal conversion layer (base material: polyimide film)) was obtained.

A pressure-sensitive adhesive was applied to the first photothermal conversion layer (base material) side of the laminate to form a pressure-sensitive adhesive layer having a thickness of 10 µm. In addition, a pressure-sensitive adhesive was applied to the second photothermal conversion layer side of the laminate to form a pressure-sensitive adhesive layer having a thickness of 30 µm. A pressure-sensitive adhesive sheet obtained as described above was subjected to the above-mentioned evaluations. The results are shown in Table 1.

The pressure-sensitive adhesives for forming the pressure-sensitive adhesive layer on the first photothermal conversion layer (base material) side and the pressure-sensitive adhesive layer on the second photothermal conversion layer side were prepared as described below. That is, 95 parts by weight of 2-ethylhexyl acrylate, 5 parts by weight of acrylic acid, and 0.15 part by weight of benzoyl peroxide serving as a polymerization initiator were added into ethyl acetate, and then the mixture was heated to 70°C to provide a solution of an acrylic polymer (polymer A) in ethyl acetate. Further, 0.4 part by weight of an epoxy-based cross-linking agent (manufactured by Mitsubishi Gas Chemical Company, Inc., product name: "TETRAD-C") was added to the solution in ethyl acetate to provide a pressure-sensitive adhesive for the pressure-sensitive adhesive layer on the second photothermal conversion layer side. In addition, 2 parts by weight of an epoxy-based cross-linking agent (manufactured by Mitsubishi Gas Chemical Company, Inc., product name: "TETRAD-C") were added to the solution in ethyl acetate to provide a pressure-sensitive adhesive for the pressure-sensitive adhesive layer on the first photothermal conversion layer (base material) side.

The transmittance of the pressure-sensitive adhesive layer on the second photothermal conversion layer side for light having a wavelength of 355 nm, the transmittance thereof for light having a wavelength of 600 nm, and the transmittance thereof for light having a wavelength of 1,032 nm were 91.1%, 92.8%, and 93.91%, respectively.

### [Example 2 to Example 4]

Pressure-sensitive adhesive sheets were each produced in the same manner as in Example 1 except that the thickness of the second photothermal conversion layer was set as shown in Table 1. The resultant pressure-sensitive adhesive sheets were subjected to the above-mentioned evaluations. The results are shown in Table 1.

### [Example 5]

A pressure-sensitive adhesive sheet was produced in the same manner as in Example 1 except that: the composition B for forming a second photothermal conversion layer was used instead of the composition A for forming a second photothermal conversion layer; and the thickness of the second photothermal conversion layer was set to 5 µm. The resultant pressure-sensitive adhesive sheet was subjected to the above-mentioned evaluations. The results are shown in Table 1.

### [Example 6]

A pressure-sensitive adhesive sheet was produced in the same manner as in Example 1 except that: the composition C for forming a second photothermal conversion layer was used instead of the composition A for forming a second photothermal conversion layer; and the thickness of the second photothermal conversion layer was set to 20 µm. The resultant pressure-sensitive adhesive sheet was subjected to the above-mentioned evaluations. The results are shown in Table 1.

### [Example 7]

A pressure-sensitive adhesive sheet was produced in the same manner as in Example 1 except that: a polyethylene terephthalate film (manufactured by Toray Industries, Inc., product name: "Lumirror S27", thickness: 38 µm) was used instead of the polyimide film (manufactured by Du Pont-Toray Co., Ltd., product name: "Kapton 100H", thickness: 25 µm); and the thickness of the second photothermal conversion layer was set to 5 µm. The resultant pressure-sensitive adhesive sheet was subjected to the above-mentioned evaluations. The results are shown in Table 2.

### [Example 8]

A pressure-sensitive adhesive sheet was produced in the same manner as in Example 7 except that the composition F for forming a second photothermal conversion layer was used instead of the composition A for forming a second photothermal conversion layer. The resultant pressure-sensitive adhesive sheet was subjected to the above-mentioned evaluations. The results are shown in Table 2.

### [Example 9]

A pressure-sensitive adhesive sheet was produced in the same manner as in Example 1 except that: a polyethylene naphthalate film (manufactured by Teijin Film Solutions, product name: "Teonex (trademark) film Q51C-50", thickness: 50 µm) was used instead of the polyimide film (manufactured by Du Pont-Toray Co., Ltd., product name: "Kapton 100H", thickness: 25 µm); and the thickness of the second photothermal conversion layer was set to 5 µm. The resultant pressure-sensitive adhesive sheet was subjected to the above-mentioned evaluations. The results are shown in Table 2.

### [Example 10]

A pressure-sensitive adhesive sheet was produced in the same manner as in Example 1 except that: a polyetheretherketone film (manufactured by Kurabo Industries Ltd., product name: "EXPEEK", thickness: 12 µm) was used instead of the polyimide film (manufactured by Du Pont-Toray Co., Ltd., product name: "Kapton 100H", thickness: 25 µm); and the thickness of the second photothermal conversion layer was set to 5 µm. The resultant pressure-sensitive adhesive sheet was subjected to the above-mentioned evaluations. The results are shown in Table 2.

### [Comparative Example 1]

Pressure-sensitive adhesive layers (thickness: 10 µm and 30 µm) were formed on both sides of a polyimide film (manufactured by Du Pont-Toray Co., Ltd., product name: "Kapton 100H", thickness: 25 µm) to provide a pressure-sensitive adhesive sheet. The resultant pressure-sensitive adhesive sheet was subjected to the above-mentioned evaluations. The results are shown in Table 3.

### [Comparative Example 2]

Pressure-sensitive adhesive layers (thickness: 10 µm and 30 µm) were formed on both sides of a polyethylene terephthalate film (manufactured by Toray Industries, Inc., Ltd., product name: "Lumirror S27", thickness: 38 µm) to provide a pressure-sensitive adhesive sheet. The resultant pressure-sensitive adhesive sheet was subjected to the above-mentioned evaluations. The results are shown in Table 3.

### [Comparative Example 3]

A resin composition was prepared in the same manner as in Production Example 1 except that the near infrared ray absorber (cesium tungsten oxide dispersion liquid, product name: "YMF-02A", manufactured by Sumitomo Metal Mining Co., Ltd.) was not added.

A laminate was obtained, and a pressure-sensitive adhesive sheet was further obtained in the same manner as in Example 1 except that a resin layer having a thickness of 5 µm was formed by using the resin composition instead of the composition A for forming a second photothermal conversion layer. The resultant pressure-sensitive adhesive sheet was subjected to the above-mentioned evaluations. The results are shown in Table 3.

### [Comparative Example 4]

100 Parts by weight of a black printing ink "NB300" (manufactured by Dainichiseika Color & Chemicals Mfg. Co., Ltd.) with carbon black and 5 parts by weight of an isocyanate-based curing agent (manufactured by Dainichiseika Color & Chemicals Mfg. Co., Ltd., product name: "Lamic B Hardener") were mixed to prepare a composition I for forming a second photothermal conversion layer. The "NB300" contained a polyurethane-based vinyl acetate-vinyl chloride copolymer serving as a binder resin, and an intensity peak that was considered to be derived from urethane was observed by IR.

The composition I for forming a second photothermal conversion layer was applied to one side of a polyethylene terephthalate film (manufactured by Toray Industries, Inc., product name: "Lumirror S105", thickness: 25 µm) with a gravure coater so that its thickness after solvent volatilization (drying) became 0.2 µm. After that, the composition was dried to provide a laminate (second photothermal conversion layer/first photothermal conversion layer (base material: polyethylene terephthalate film)).

A pressure-sensitive adhesive was applied to the first photothermal conversion layer (base material) side of the laminate to form a pressure-sensitive adhesive layer having a thickness of 10 µm. In addition, a pressure-sensitive adhesive was applied to the second photothermal conversion layer side of the laminate to form a pressure-sensitive adhesive layer having a thickness of 30 µm. The resultant pressure-sensitive adhesive sheet was subjected to the above-mentioned evaluations. The results are shown in Table 3.

The composition of each of the pressure-sensitive adhesives was set to be the same as that of Example 1.

### [Comparative Example 5]

100 Parts by weight of a black printing ink "CVL-PR" (manufactured by DIC Corporation) with carbon black and 4 parts by weight of an isocyanate-based curing agent (manufactured by DIC Corporation, product name: "CVL Hardener No. 10") were mixed to prepare a composition II for forming a second photothermal conversion layer. The "CVL-PR" contained a polyurethane-based vinyl acetate -vinyl chloride copolymer serving as a binder resin, and an intensity peak that was considered to be derived from urethane was observed by IR.

The composition II for forming a second photothermal conversion layer was applied to one side of a polyethylene terephthalate film (manufactured by Toray Industries, Inc., product name: "Lumirror S105", thickness: 25 µm) with a gravure coater so that its thickness after solvent volatilization (drying) became 3 µm. After that, the composition was dried to provide a laminate (second photothermal conversion layer/first photothermal conversion layer (base material: polyethylene terephthalate film)).

A pressure-sensitive adhesive was applied to the first photothermal conversion layer (base material) side of the laminate to form a pressure-sensitive adhesive layer having a thickness of 10 µm. In addition, a pressure-sensitive adhesive was applied to the second photothermal conversion layer side of the laminate to form a pressure-sensitive adhesive layer having a thickness of 30 µm. The resultant pressure-sensitive adhesive sheet was subjected to the above-mentioned evaluations. The results are shown in Table 3.

The composition of each of the pressure-sensitive adhesives was set to be the same as that of Example 1.

**Table 1**

| | | | | Example 1 | Example 2 | Example 3 | Example 4 | Example 5 | Example 6 |
|---|---|---|---|---|---|---|---|---|---|
| First photothermal conversion layer | Composition | Material | | PI (Polyimide) | PI (Polyimide) | PI (Polyimide) | PI (Polyimide) | PI (Polyimide) | PI (Polyimide) |
| | Configuratio n | Thickness [µm] | | 25 | 25 | 25 | 25 | 25 | 25 |
| | Characterist ics | Tensile modulus of elasticity E'(LTHC) at 200°C [MPa] | | 1,585 | 1,585 | 1,585 | 1,585 | 1,585 | 1,585 |
| | | TGA 5% weight loss temperature [°C] | | 589.1 | 589.1 | 589.1 | 589.1 | 589.1 | 589.1 |
| Second photothermal conversion layer | Composition | Material | | Acrylic | Acrylic | Acrylic | Acrylic | Acrylic | Acrylic |
| | | UV oligomer (1) | | UV curable polymer acrylate | UV curable polymer acrylate | UV curable polymer acrylate | UV curable polymer acrylate | UV curable polymer acrylate | UV curable polymer acrylate |
| | | | Parts | 100 | 100 | 100 | 100 | 100 | 100 |
| | | | Presence or absence of incorporatio n of polyfunction al acrylate | Pentaerythri tol-based | Pentaerythri tol-based | Pentaerythri tol-based | Pentaerythri tol-based | Pentaerythri tol-based | Pentaerythri tol-based |
| | | | Monomer component whose homopolymer has Tg equal to or more than 40°C | MMA | MMA | MMA | MMA | MMA | MMA |
| | | UV oligomer (2) | | - | - | - | - | - | - |
| | | | Parts | - | - | - | - | - | - |
| | | | Presence or absence of incorporatio n of polyfunction al acrylate | - | - | - | - | - | - |
| | | | Monomer component whose homopolymer has Tg equal to or more than 40°C | - | - | - | - | - | - |
| | | Kind of photopolymerization initiator | | α-Hydroxyketon e-based | α-Hydroxyketon e-based | α-Hydroxyketon e-based | α-Hydroxyketon e-based | α-Hydroxyketon e-based | α-Hydroxyketon e-based |
| | | Product name and parts | Omnirad 127D (0.5) | Omnirad 127D (0.5) | Omnirad 127D (0.5) | Omnirad 127D (0.5) | Omnirad 127D (0.5) | Omnirad 127D (0.5) | |
| | | Photothermal conversion material | Cesium tungsten oxide | Cesium tungsten oxide | Cesium tungsten oxide | Cesium tungsten oxide | Cesium tungsten oxide | Cesium tungsten oxide | |
| | | Product name and parts | YMF-02A (15) | YMF-02A (15) | YMF-02A (15) | YMF-02A (15) | YMF-02A (7.5) | YMF-02A (23) | |
| | Configuratio n | Thickness [µm] | 2 | 5 | 10 | 20 | 5 | 20 | |
| | Characterist ics | TGA 5% weight loss temperature [°C] | 345.0 | 345.0 | 345.0 | 345.0 | 353.8 | 335.6 | |
| Evaluation (laminate A (first photothermal conversion layer/second photothermal conversion layer)) | Configuratio n | Thickness [µm] | 27 | 30 | 35 | 45 | 30 | 45 | |
| | Optical characterist ic | Transmittance at 355 nm [%] | 0.00 | 0.00 | 0.00 | 0.00 | 0.00 | 0.00 | |
| | | Transmittance at 600 nm [%] | 75.65 | 71.93 | 63.35 | 55.46 | 75.89 | 52.07 | |
| | | Transmittance at 1,032 nm [%] | 62.18 | 39.98 | 11.65 | 3.63 | 73.38 | 1.60 | |
| | <Debonding property by IR laser> | | ○ | ○ | ○ | ○ | ○ | ○ | |
| | <Heat Resistance> | TGA 5% weight loss temperature [°C] | 423.5 | 385.6 | 368.7 | 357 | 390.3 | 348.2 | |
| | <Chemical Resistance> | Appearance after about 0.1 mL of NMP is dropped and after being left at 25°C for 15 minutes | ○ | ○ | ○ | ○ | ○ | ○ | |
| | <Visibility through film> | | ○ | ○ | ○ | ○ | ○ | ○ | |

| | | | | | | | | |
|---|---|---|---|---|---|---|---|---|
| Pressure-sensitive adhesive sheet | Pressure-sensitive adhesive layer on device side (first photothermal conversion layer side) | Normal pressure-sensitive adhesive strength to PET#25 [N/20 mm] | 0.82 | 0.82 | 0.82 | 0.82 | 0.82 | 0.82 |
| | Pressure-sensitive adhesive layer on optically transparent resin substrate side (second photothermal conversion layer side) | Normal pressure-sensitive adhesive strength to SUS430 [N/20 mm] | 3.80 | 3.77 | 3.56 | 3.52 | 3.78 | 3.7 |
| | Optical characterist ic | Transmittance at 355 nm [%] | 0.00 | 0.00 | 0.00 | 0.00 | 0.00 | 0.00 |
| | | Transmittance at 600 nm [%] | 75.30 | 70.30 | 62.10 | 53.20 | 73.70 | 50. 30 |
| | | Transmittance at 1,032 nm [%] | 62.10 | 39.10 | 10.00 | 3.20 | 72.05 | 1.20 |
| | <Debonding property by IR laser (wavelength: 1,032 nm)> | Debondability | ○ | ○ | ○ | ○ | ○ | ○ |
| | | Site to be debonded | First photothermal conversion layer/second photothermal conversion layer | First photothermal conversion layer/second photothermal conversion layer | First photothermal conversion layer/second photothermal conversion layer | First photothermal conversion layer/second photothermal conversion layer | First photothermal conversion layer/second photothermal conversion layer | First photothermal conversion layer/second photothermal conversion layer |
| | | Layer having photothermal conversion function | Second photothermal conversion layer | Second photothermal conversion layer | Second photothermal conversion layer | Second photothermal conversion layer | Second photothermal conversion layer | Second photothermal conversion layer |
| | <Debonding property by UV laser (wavelength: 355 nm)> | Debondability | ○ | ○ | ○ | ○ | ○ | ○ |
| | | Site to be debonded | First photothermal conversion layer/second photothermal conversion layer | First photothermal conversion layer/second photothermal conversion layer | First photothermal conversion layer/second photothermal conversion layer | First photothermal conversion layer/second photothermal conversion layer | First photothermal conversion layer/second photothermal conversion layer | First photothermal conversion layer/second photothermal conversion layer |
| | | Layer having photothermal conversion function | First photothermal conversion layer | First photothermal conversion layer | First photothermal conversion layer | First photothermal conversion layer | First photothermal conversion layer | First photothermal conversion layer |
| | <Visibility through pressure-sensitive adhesive Sheet> | Visibility of adherend | ○ | ○ | ○ | ○ | ○ | ○ |

**Table 2**

| | | | | Example 7 | Example 8 | Example 9 | Example 10 |
|---|---|---|---|---|---|---|---|
| First photothermal conversion layer | Composition | Material | | PET | PET | PEN | PEEK |
| | Configuration | Thickness [µm] | | 38 | 38 | 50 | 12 |
| | Characteristics | Tensile modulus of elasticity E'(LTHC) at 200°C [MPa] | | 316 | 316 | 331 | 813 |
| | | TGA 5% weight loss temperature [°C] | | 390.4 | 390.4 | 405.4 | 551.0 |
| Second photothermal conversion layer | Composition | Material | | Acrylic | Acrylic | Acrylic | Acrylic |
| | | UV oligomer (1) | | UV curable polymer acrylate | - | UV curable polymer acrylate | UV curable polymer acrylate |
| | | | Parts | 100 | - | 100 | 100 |
| | | | Presence or absence of incorporation of polyfunctional acrylate | Pentaerythrito 1-based | - | Pentaerythrito 1-based | Pentaerythrito 1-based |
| | | | Monomer component whose homopolymer has Tg equal to or more than 40°C | MMA | - | MMA | MMA |
| | | UV oligomer (2) | | - | UV curable polymer acrylate | - | - |
| | | | Parts | - | 100 | - | - |
| | | | Presence or absence of incorporation of polyfunctional acrylate | - | - | - | - |
| | | | Monomer component whose homopolymer has Tg equal to or more than 40°C | - | MMA | - | - |
| | | Kind of photopolymerization initiator | | α-Hydroxyketone-based | α-Hydroxyketone-based | α-Hydroxyketone-based | α-Hydroxyketone-based |
| | | Product name and parts | | Omnirad 127D (0.5) | Omnirad 127D (0.5) | Omnirad 127D (0.5) | Omnirad 127D (0.5) |
| | | Photothermal conversion material | | Cesium tungsten oxide | Cesium tungsten oxide | Cesium tungsten oxide | Cesium tungsten oxide |
| | | Product name and parts | | YMF-02A (15) | YMF-02A (15) | YMF-02A (15) | YMF-02A (15) |
| | Configuration | Thickness [µm] | | 5 | 5 | 5 | 5 |
| | Characteristics | TGA 5% weight loss temperature [°C] | | 345.0 | 323.4 | 345.0 | 345.0 |
| Evaluation (laminate A | Configuration | Thickness [µm] | | 43 | 43 | 55 | 17 |
| | Optical | Transmittance at 355 nm [%] | | 46.05 | 42.91 | 7.32 | 0.20 |
| (first photothermal conversion layer/second photothermal conversion layer)) | characteristics | Transmittance at 600 nm [%] | 69.36 | 69.21 | 71.80 | 76.70 | |
| | | Transmittance at 1,032 nm [%] | 8.81 | 9.33 | 23.40 | 25.30 | |
| | <Debonding property by IR laser> | | ○ | ○ | ○ | ○ | |
| | <Heat Resistance> | TGA 5% weight loss temperature [°C] | 378.3 | 365.1 | 390.3 | 368.9 | |
| | <Chemical Resistance> | Appearance after about 0.1 mL of NMP is dropped and after being left at 25°C for 15 minutes | ○ | × | ○ | ○ | |
| | <Visibility through film> | | ○ | ○ | ○ | ○ | |

| | | | | | | |
|---|---|---|---|---|---|---|
| Pressure-sensitive adhesive sheet | Pressure-sensitive adhesive layer on device side (first photothermal conversion layer side) | Normal pressure-sensitive adhesive strength to PET#25 [N/20 mm] | 0.82 | 0.82 | 0.82 | 0.82 |
| | Pressure-sensitive adhesive layer on optically transparent resin substrate side (second photothermal conversion layer side) | Normal pressure-sensitive adhesive strength to SUS430 [N/20 mm] | 3.42 | 3.42 | 2.97 | 3.78 |
| | Optical characteristics | Transmittance at 355 nm [%] | 45.29 | 42.10 | 6.70 | 0.00 |
| | | Transmittance at 600 nm [%] | 68.20 | 67.87 | 68.50 | 71.78 |
| | | Transmittance at 1,032 nm [%] | 7.60 | 8.56 | 21.00 | 22.87 |
| | <Debonding property by IR laser (wavelength: 1,032 nm)> | Debondability | ○ | ○ | ○ | ○ |
| | | Site to be debonded | First photothermal conversion layer/second photothermal conversion layer | First photothermal conversion layer/second photothermal conversion layer | First photothermal conversion layer/second photothermal conversion layer | First photothermal conversion layer/second photothermal conversion layer |
| | | Layer having photothermal conversion function | Second photothermal conversion layer | Second photothermal conversion layer | Second photothermal conversion layer | Second photothermal conversion layer |
| | <Debonding property by UV laser (wavelength: 355 nm)> | Debondability | ○ | ○ | ○ | ○ |
| | | Site to be debonded | First photothermal conversion layer/second photothermal conversion layer | First photothermal conversion layer/second photothermal conversion layer | First photothermal conversion layer/second photothermal conversion layer | First photothermal conversion layer/second photothermal conversion layer |
| | | Layer having photothermal conversion function | Second photothermal conversion layer | Second photothermal conversion layer | First photothermal conversion layer | First photothermal conversion layer |
| | <Visibility through pressure-sensitive adhesive Sheet> | Visibility of adherend | ○ | ○ | ○ | ○ |

**Table 3**

| | | | | Comparative Example 1 | Comparative Example 2 | Comparative Example 3 | Comparative Example 4 | Comparative Example 5 |
|---|---|---|---|---|---|---|---|---|
| First photothermal conversion layer | Composition | Material | | PI (Polyimide) | PET | PET | Black printed PET (1) | Black printed PET (2) |
| | Configuration | Thickness [µm] | | 25 | 38 | 38 | 25 | 25 |
| | Characteristics | Tensile modulus of elasticity E'(LTHC) at 200°C [MPa] | | 1,585 | 316 | 316 | 316 | 316 |
| | | TGA 5% weight loss temperature [°C] | | 589.1 | 390.4 | 390.4 | 390.4 | 390.4 |
| Second photothermal conversion layer | Composition | Material | | - | - | Acrylic | Polyurethane/viny l chloride or vinyl acetate-based | Polyurethane/viny l chloride or vinyl acetate-based |
| | | UV Oligomer (1) | | - | - | UV curable polymer acrylate | Two-component curable (NB300 805 black ink) | Two-component curable (Panacea CVL-SP Special-purpose conch black ink) |
| | | | Parts | - | - | 100 | 100 | 100 |
| | | | Presence or absence of incorporation of polyfunctional acrylate | - | - | Pentaerythrit ol-based | - | - |
| | | | Monomer component whose homopolymer has Tg equal to or more than 40°C | - | - | MMA | - | - |
| | | UV oligomer (2) | | - | - | - | Isocyanate-based curing agent | Isocyanate-based curing agent |
| | | | Product name and parts | - | - | - | Lamic B (5) | CVL Hardener No. 10 (4) |
| | | | Presence or absence of incorporation of polyfunctional acrylate | - | - | - | - | - |
| | | | Monomer component whose homopolymer has Tg equal to or more than 40°C | - | - | - | - | - |
| | | Kind of photopolymerization initiator | - | - | α-Hydroxyketone -based | Diluted solvent | Diluted solvent | |
| | | Product name and parts | - | - | Omnirad 127D (0.5) | Daireducer V No. 20 (40) | Daireducer V No. 20 (40) | |
| | | Photothermal conversion material | - | - | - | Carbon black | Carbon black | |
| | | Product name and parts | - | - | - | - | - | |
| | Configuration | Thickness [µm] | 0 | 0 | 5 | 0.2 | 3 | |
| | Characteristics | TGA 5% weight loss temperature [°C] | - | - | 355.2 | 298.9 | 240.6 | |
| Evaluation (laminate A (first photothermal conversion layer/second photothermal conversion layer)) | Configuration | Thickness [µm] | 25 | 38 | 43 | 25.2 | 28 | |
| | Optical characteristics | Transmittance at 355 nm [%] | 0.00 | 83.21 | 83.21 | 0.69 | 0.00 | |
| | | Transmittance at 600 nm [%] | 75.93 | 89.48 | 89.48 | 3.89 | 0.50 | |
| | | Transmittance at 1,032 nm [%] | 87.39 | 90.65 | 90.65 | 43.66 | 2.40 | |
| | <Debonding property by IR laser> | | × | × | × | ○ | ○ | |
| | <Heat Resistance> | TGA 5% weight loss temperature [°C] | 589.1 | 390.4 | 391.4 | 393.4 | 356.9 | |
| | <Chemical Resistance> | Appearance after about 0.1 mL of NMP is dropped and after being left at 25°C for 15 minutes | - | - | ○ | × | × | |
| | <Visibility through film> | | ○ | ○ | ○ | × | × | |

| | | | | | | | |
|---|---|---|---|---|---|---|---|
| Pressure-sensitive adhesive sheet | Pressure-sensitive adhesive layer on device side (first photothermal conversion layer side) | Normal pressure-sensitive adhesive strength to PET#25 [N/20 mm] | 0.82 | 0.82 | 0.82 | 0.82 | 0.82 |
| | Pressure-sensitive adhesive layer on optically transparent resin substrate side (second photothermal conversion layer side) | Normal pressure-sensitive adhesive strength to SUS430 [N/20 mm] | 3.78 | 3.23 | 3.43 | 3.84 | 3.89 |
| | Optical characteristics | Transmittance at 355 nm [%] | 0.00 | 81.60 | 81.10 | 0.34 | 0.00 |
| | | Transmittance at 600 nm [%] | 75.30 | 88.20 | 89.30 | 3.34 | 0.44 |
| | | Transmittance at 1,032 nm [%] | 86.40 | 89.90 | 90.10 | 42.01 | 2.26 |
| | <Debonding property by IR laser (wavelength: 1,032 nm)> | Debondability | × | × | × | ○ | ○ |
| | | Site to be debonded | - | - | - | Second photothermal conversion layer (cohesive failure) | Second photothermal conversion layer (cohesive failure) |
| | | Layer having photothermal conversion function | - | - | - | Second photothermal conversion layer | Second photothermal conversion layer |
| | <Debonding property by UV laser (wavelength: 355 nm)> | Debondability | ○ | × | × | ○ | ○ |
| | | Site to be debonded | First photothermal conversion layer/second photothermal conversion layer | - | - | Photothermal conversion layer (cohesive failure) | Photothermal conversion layer (cohesive failure) |
| | | Layer having photothermal conversion function | First photothermal conversion layer | - | - | Second photothermal conversion layer | Second photothermal conversion layer |
| | <Visibility through pressure-sensitive adhesive Sheet> | Visibility of adherend | ○ | ○ | ○ | × | × |

As is apparent from Table 1, the pressure-sensitive adhesive sheet of the present invention is excellent in transparency of visible light, and shows debonding properties to both of IR laser light and UV laser light.

### Reference Signs List

- **10**: first photothermal conversion layer
- **20**: second photothermal conversion layer
- **30**: pressure-sensitive adhesive layer
- **40**: another pressure-sensitive adhesive layer
- **110**: pressure-sensitive adhesive sheet for temporarily fixing electronic part

## Claims

1. A pressure-sensitive adhesive sheet for temporarily fixing an electronic part, comprising:
a laminated structure A including a first photothermal conversion layer and a second photothermal conversion layer arranged on at least one side of the first photothermal conversion layer; and
a pressure-sensitive adhesive layer arranged on at least one side of the laminated structure A,
wherein the pressure-sensitive adhesive sheet has a transmittance for light having a wavelength of 1,032 nm of 75% or less, and
wherein the pressure-sensitive adhesive sheet has a transmittance for light having a wavelength of 355 nm of 50% or less.

2. The pressure-sensitive adhesive sheet for temporarily fixing an electronic part according to claim 1, wherein the first photothermal conversion layer is a layer capable of absorbing UV light.

3. The pressure-sensitive adhesive sheet for temporarily fixing an electronic part according to claim 1, wherein the first photothermal conversion layer includes a polyimide-based resin, a polyester-based resin, or a polyetheretherketone-based resin.

4. The pressure-sensitive adhesive sheet for temporarily fixing an electronic part according to claim 1, wherein the first photothermal conversion layer has a 5% weight loss temperature of 300°C or more.

5. The pressure-sensitive adhesive sheet for temporarily fixing an electronic part according to claim 1, wherein the second photothermal conversion layer is a layer capable of absorbing a near infrared ray.

6. The pressure-sensitive adhesive sheet for temporarily fixing an electronic part according to claim 1, wherein the second photothermal conversion layer contains a near infrared ray absorber.

7. The pressure-sensitive adhesive sheet for temporarily fixing an electronic part according to claim 6, wherein the near infrared ray absorber is a substance containing a tungsten element.

8. The pressure-sensitive adhesive sheet for temporarily fixing an electronic part according to claim 6, wherein the near infrared ray absorber is a substance containing a cesium element.

9. The pressure-sensitive adhesive sheet for temporarily fixing an electronic part according to claim 1, wherein the second photothermal conversion layer has a 5% weight loss temperature of 300°C or more.

10. A method of treating an electronic part, comprising subjecting an electronic part to predetermined treatment after arranging the electronic part on the pressure-sensitive adhesive sheet of any one of claims 1 to 9.

11. The method of treating an electronic part according to claim 10, wherein the treatment is grinding processing, dicing processing, die bonding, wire bonding, etching, vapor deposition, chemical cleaning, molding, rewiring layer formation, through-hole formation, or protection of a device surface.

12. A method of separating, from a support, an electronic part that has been temporarily fixed thereto, the method comprising:
arranging the pressure-sensitive adhesive sheet for temporarily fixing an electronic part of any one of claims 1 to 9 on the support;
arranging the electronic part on the pressure-sensitive adhesive sheet for temporarily fixing an electronic part; and then
irradiating the pressure-sensitive adhesive sheet with light to separate the first photothermal conversion layer and the second photothermal conversion layer from each other.

13. The method of separating, from a support, an electronic part that has been temporarily fixed thereto according to claim 12, wherein the light is laser light.

14. The method of separating, from a support, an electronic part that has been temporarily fixed thereto according to claim 13, wherein the laser light has a wavelength of 800 nm or more.

15. The method of separating, from a support, an electronic part that has been temporarily fixed thereto according to claim 13, wherein the laser light has a wavelength of 380 nm or less.
